# EUROPEAN PATENT SPECIFICATION

(11) **EP 0 591 918 B1**
(45) Date of publication and mention of the grant of the patent: **28.07.1999**
(21) Application number: 93116068.3
(22) Date of filing: 05.10.1993
(51) Int. Cl.: H03H 9/54, H03H 3/00, H03H 9/17

(54) **Electro-acoustic hybrid integrated circuit and manufacturing method thereof**
Elektroakustische Hybride integrierte Schaltung und Methode zu deren Herstellung
Circuit intégré électro-acoustique hybride et méthode pour sa fabrication

(30) Priority: 05.10.1992 JP 26615892; 13.10.1992 JP 27400292; 13.10.1992 JP 27400392
(43) Date of publication of application: 13.04.1994
(73) Proprietor: MATSUSHITA ELECTRIC INDUSTRIAL CO., LTD., Kadoma-shi, Osaka 571-8501 (JP)
(72) Inventor: Eda, Kazuo, Nara-shi, Nara-ken (JP); Taguchi, Yutaka, Settsu-shi, Osaka (JP); Kanaboshi, Akihiro, Neyagawa-shi, Osaka (JP); Ogura, Tetsuyoshi, Yodogawa-ku, Osaka-shi, Osaka (JP)
(74) Representative: Schwabe - Sandmair - Marx

(56) References cited:
- EP-A- 0 531 985
- DE-A- 3 922 671
- US-A- 4 665 374
- PATENT ABSTRACTS OF JAPAN vol. 015, no. 423 (E-1127)28 October 1991 & JP-A-03 178 206 (NEC) 2 August 1991

## Description

### BACKGROUND OF THE INVENTION

### 1. Field of the Invention:

The present invention relates to an electro-acoustic hybrid integrated circuit which uses the conversion of sonic energy into electric energy or vice versa, in particular to a high frequency circuit such as a voltage controlled oscillator, which incorporates a semiconductor device and an electro-acoustic element such as a surface acoustic wave resonator or a quartz oscillator, and a manufacturing method thereof.

### 2. Description of the Related Art:

An electro-acoustic circuit such as a voltage controlled oscillator (VCO) comprises a transistor as an active element so as to cause the oscillation, an electro-acoustic element to resonate or oscillate at a desired frequency, as well as some electronics components such as capacitors and resistors. The electro-acoustic element is an element which converts sonic energy into electric energy or vice versa, such as a surface acoustic wave resonator of lithium niobate (LiNbO₃) or lithium tantalate (LiTaO₃) or lithium borate (Li₂B₇O₄) or a quartz oscillator.

An electro-acoustic circuit includes the following circuits. Figure **1** shows an example of a voltage controlled oscillator which comprises a surface acoustic wave resonator (SAW) as an electro-acoustic element, a transistor (Tr), varactor diodes (D) and passive components of capacitors, inductors and resistors. Figure **2** shows another example of a voltage controlled oscillator wherein a crystal resonator (X) as an electro-acoustic element is used instead of the surface wave resonator. Figure **3** shows an example of a high frequency amplifier which comprises a frequency filter (F) of quartz filter or surface acoustic wave filter, a transistor (Tr) and passive components. Figure **4** shows an example of a temperature compensated crystal oscillator (TCXO) which comprises a quartz oscillator (X), a transistor (Tr), varactor diodes (D), a thermistor (Th) and passive components. That is, these circuits include an electro-acoustic element such as a surface acoustic wave resonator, a quartz oscillator or a surface acoustic wave filter or quartz filter besides a transistor as an active component.

Previously, an electro-acoustic element was sealed in a container such as metal case in order to keep the prescribed oscillation or resonance frequency stable for a long time, as well as an electro-acoustic circuit constructed on a board by mounting various components including the electro-acoustic element thereon. However, this makes the size of the surface acoustic wave resonator or the quartz oscillator several times the size of the relevant resonance or oscillation section itself. Then for applications such as car telephones or portable telephones which are required to be compact, it is an important problem to make the size of an electro-acoustic circuit smaller.

In order to reduce the size of such an electronics circuit, it is desirable to integrate a semiconductor element including a transistor with an electro-acoustic element. For example, K. Tsubouchi et al. produces a surface acoustic wave (SAW) device by growing an aluminum nitride film as a piezoelectric substance on a silicon substrate (Zero Temperature-Coefficient SAW Devices on AlN Epitaxial Films, IEEE Transactions on Sonics and Ultrasonics, SU-32 (1985) 634 - 644). In order to realize a good oscillation or resonance characteristic, a film has to be grown epitaxially or aligned in a specified crystal axis direction. However, such an epitaxially grown or aligned film is realized only for some materials such as aluminum nitride or zinc oxide by a conventional thin film technique, while a material such as lithium niobate or lithium tantalate suitable for a surface acoustic wave resonator cannot be integrated.

As to a quartz oscillator, it is required to reduce the thickness with polishing or etching in order to produce a high frequency oscillator in the submicrowave band from 800 MHz to 1.9 GHz used for car telephones and for portable telephones. For example, A. Lepek et al. (A New Design for High Frequency Bulk Resonators, 43rd Annual Symposium on frequency Control (1989) pp. 544 - 547) reported that quartz is polished to a thickness of about 10 µm with a precise polishing technique so as to realize the oscillation at a few hundreds MHz. E. A. Gerber et al. (Advances in Microwave Acoustic Frequency Sources, IEEE Transactions on MTT 34 (1986) 1002 - 1016) also reported quartz resonators operating above 1 GHz.

However, it is very difficult to manufacture the quartz oscillator or the quartz resonator of a thickness less than 10 µm practically. If the thickness is decreased less than 10 µm, it is difficult to fix the quartz plate as an oscillator because the mechanical strength is very weak and the handling of the plate is difficult. Then, the productivity is poor and the cost is high. Practically, it is very difficult to substantially produce a voltage controlled oscillator at a high frequency of 500 MHz or higher by use of a fundamental oscillation mode of quartz oscillator. If a higher harmonic oscillator mode is used, the Q of the resonance decreases. Then, it is also difficult to produce an oscillator of high and stable performance.

In order to make a voltage controlled oscillator compact and to increase the oscillation frequency at the same time, Grudkowski et al. (Fundamental-mode VHF/UHF Miniature Acoustic Resonators and Filters on Silicon, Appl. Phys. Lett. 37 (1980) 993 - 995) prepared a ZnO film resonator above an air gap on silicon substrate so as to produce a resonator in the submicrowave band. In this case, the resonator of film thickness of a few µm can be prepared easily, and it is possible to produce a resonator in the submicrowave band. However, the temperature dependence of resonance frequency and the Q of the resonance of a ZnO film are worse than quartz oscillator. Therefore the performance of the resonator is inferior to that of a quartz oscillator.

This situation is a common problem that needed to be solved for various high frequency apparatuses such as a voltage controlled oscillator, a temperature compensation crystal oscillator and a high frequency amplifier with use of an electro-acoustic element.

The document DE 3922671 discloses an electroacoustic element in which a semiconductor substrate and a piezoelectric plate are bonded together by glueing. Document EP 531 985 forms part of the prior art under Art. 54(3) EPC for the states of DE, GB and FR and is only of consideration with regard to novelty in these states. The document discloses an electroacoustic element which has semi conductor and piezoelectric elements directly bonded to an intermediate film layer.

### SUMMARY OF THE INVENTION

One object of the present invention to provide an electro-acoustic hybrid integrated circuit suitable for various high frequency apparatuses such as a voltage controlled oscillator of smaller size, of lighter weight and of better performance.

Another object of the present invention to provide a manufacturing method of such an electro-acoustic hybrid integrated circuit.

In an electro-acoustic hybrid integrated circuit according to the present invention, an active element such as a transistor is formed on the surface of a semiconductor substrate, while an electro-acoustic element is formed with a single crystalline piezoelectric substrate. The single crystalline piezoelectric substrate is bonded through directly to the semiconductor substrate. The electro-acoustic element and the active element as well as passive components are connected so as to form an electro-acoustic circuit.

The word "direct bonding" is used because no other materials, such as organic adhesives, are used to bond two surfaces of two inorganic plates. The direct bonding can be formed between two hydrophilic surfaces of inorganic materials.

When the electro-acoustic hybrid integrated circuit is manufactured, pretreatment processes necessary for forming an active element are performed first on the semiconductor substrate at processing temperatures higher than the heat treatment temperature for direct bonding. Then, a thin film including silicon is formed on at least either the semiconductor substrate and the single crystalline piezoelectric element, and the semiconductor substrate directly with the electro-acoustic element. Next, post treatment processes for forming the active element and for the metallization are performed at a processing temperature lower than the heat treatment temperature for direct bonding and processes for forming an electro-acoustic element on the single crystalline piezoelectric element. Thus, an active element and the electro-acoustic element are integrated as a hybrid integrated circuit.

One advantage of the present invention is that an electro-acoustic circuit can be produced compactly.

Another advantage of the present invention is that the oscillation above 1 GHz can be performed.

The invention is defined by the appended claims.

### BRIEF DESCRIPTION OF THE DRAWINGS

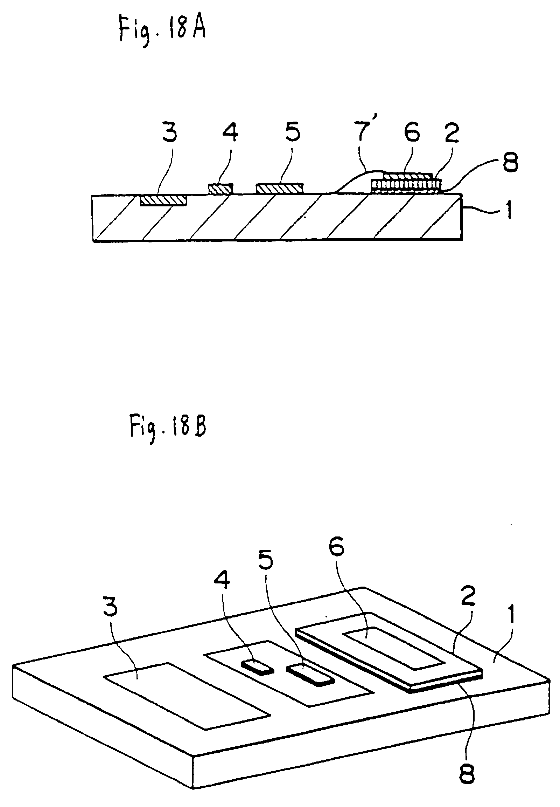

These and other objects and features of the present invention will become clear from the following description taken in conjunction with the preferred embodiments thereof with reference to the accompanying drawings, and in which: figures 18 to 29 depict art relating to the invention for the states of GB, DE and FR. Furthermore :

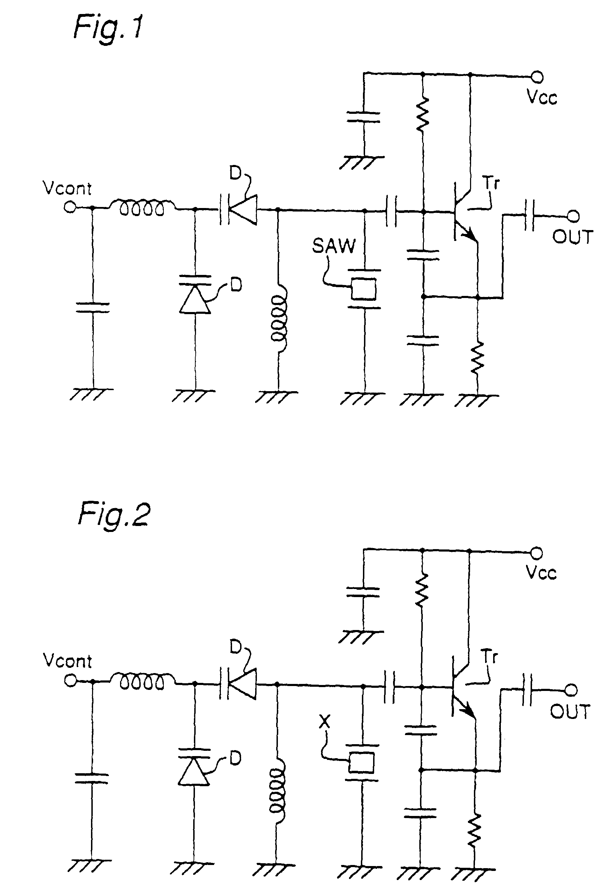

Figure **1** is a circuit diagram of a voltage controlled oscillator with use of surface wave resonator;
Figure **2** is a circuit diagram of a voltage controlled oscillator with use of a quartz oscillator;

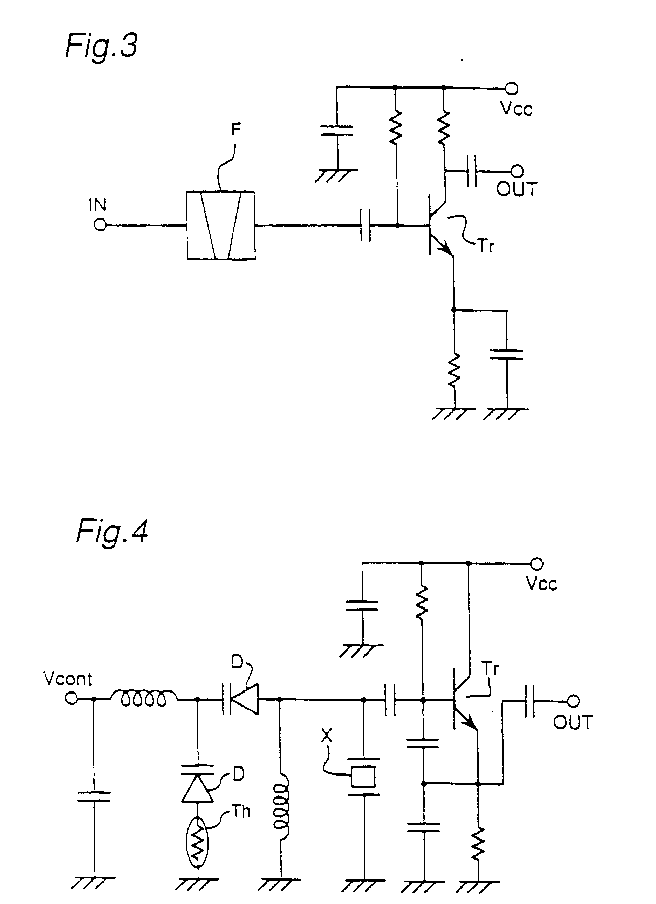

Figure **3** is a circuit diagram of a high frequency amplifier;
Figure **4** is a circuit diagram of a temperature compensated crystal oscillator;

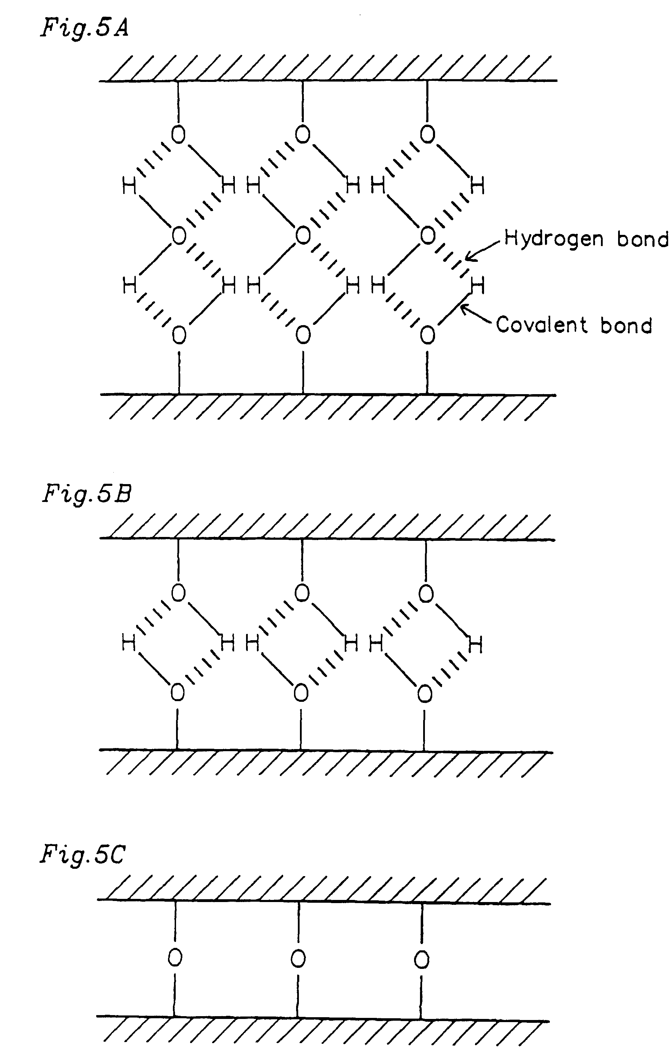

Figures **5A** to **5C** illustrate the mechanism of the formation of the direct bonding;

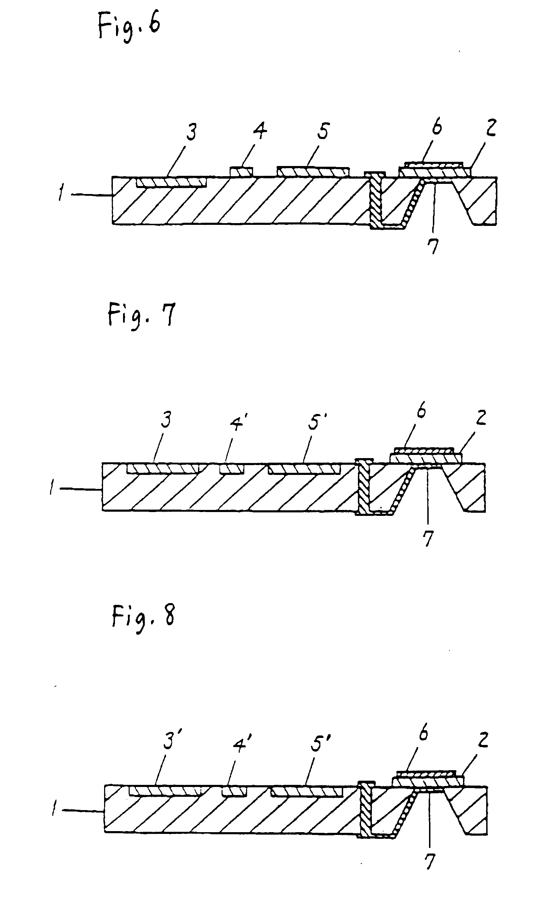

Figure **6** is a sectional view of the structure of Example 1 of the present invention;
Figure **7** is a sectional view of the structure of Example 2 of the present invention;
Figure **8** is a sectional view of the structure of Example 3 of the present invention;

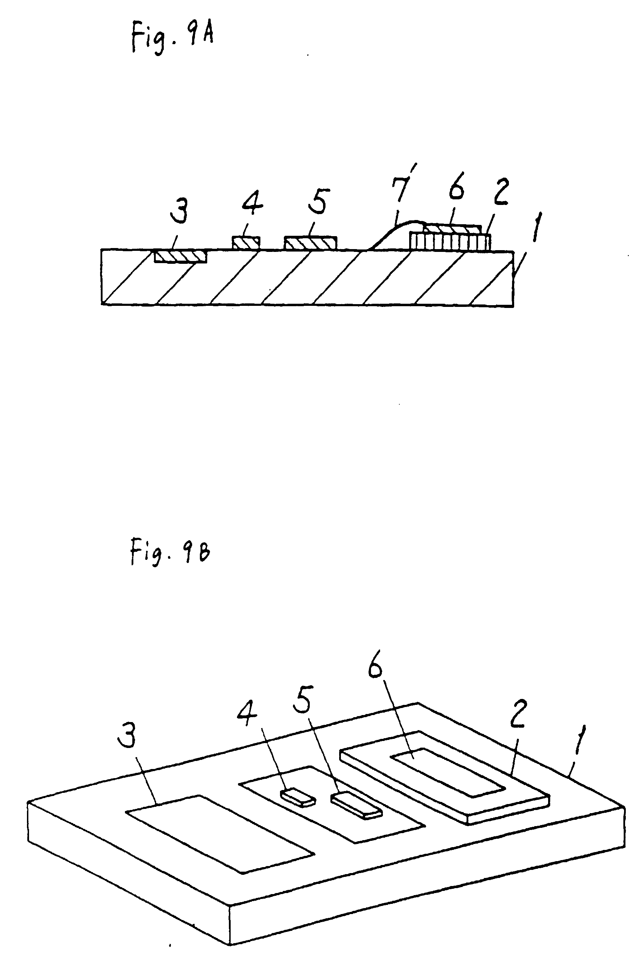

Figure **9A** is a sectional view of the structure of Example 8 of the present invention;
Figure **9B** is a perspective view of the structure of Example 8 of the present invention;

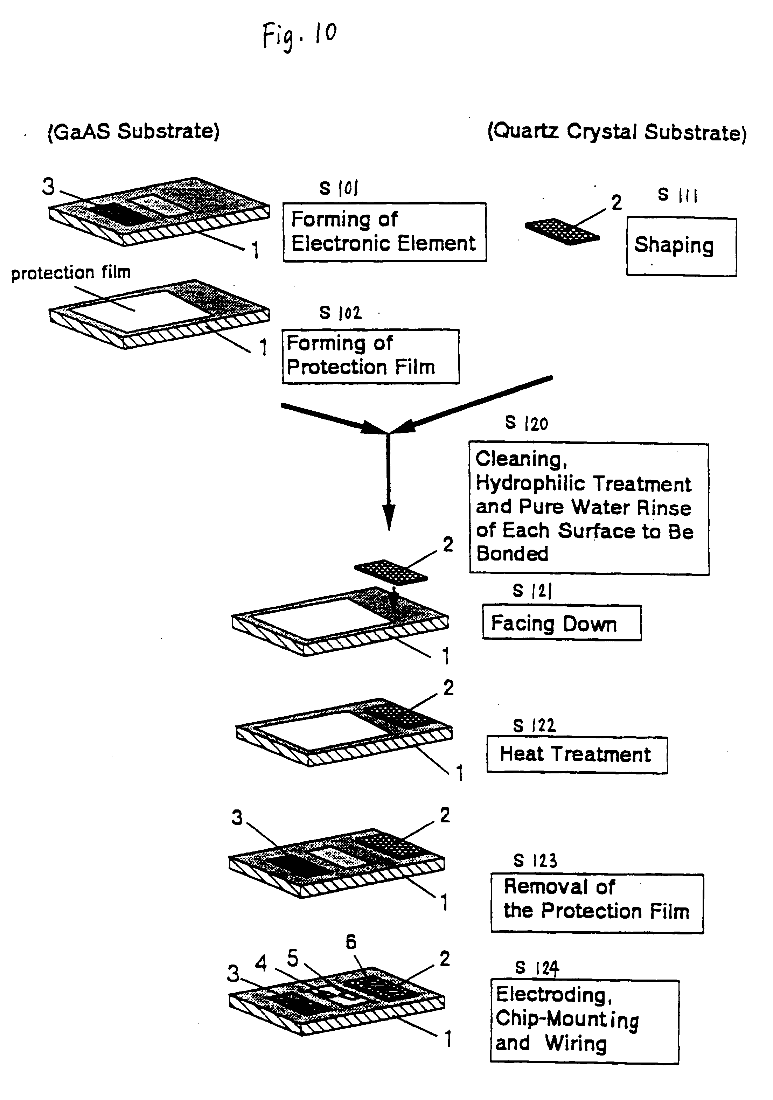

Figure **10** illustrates the manufacture flow chart of Example 10 of the present invention;

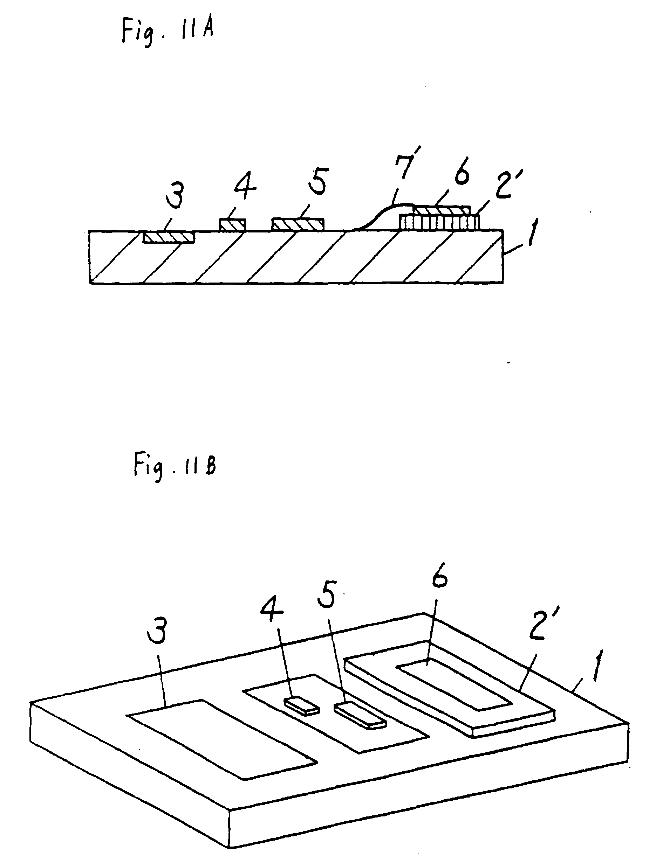

Figure **11A** is a sectional view of the structure of Example 11 of the present invention;
Figure **11B** is a perspective view of the structure of Example 11 of the present invention;

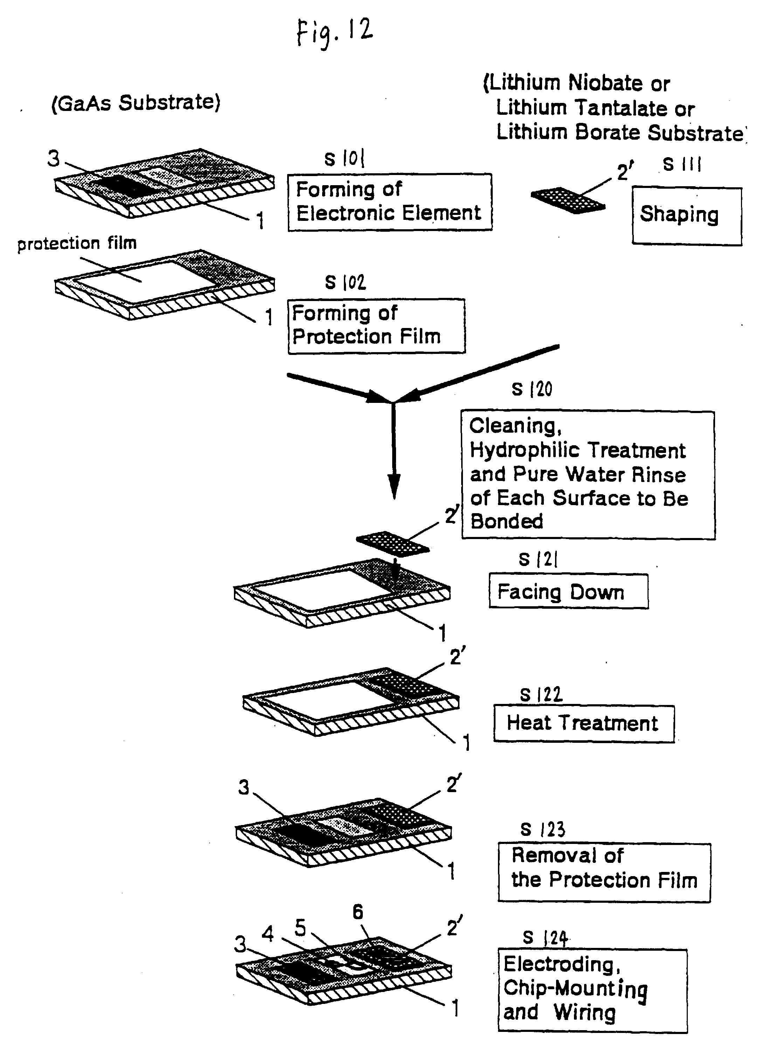

Figure **12** illustrates the manufacture flow chart of Example 12 of the present invention;
Figure **13A** is a sectional view of the structure of Example 13 of the present invention;

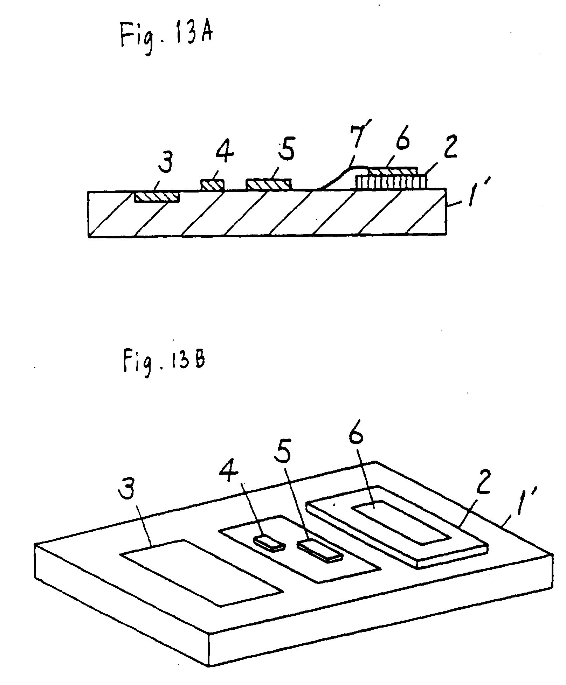

Figure **13B** is a perspective view of the structure of Example 13 of the present invention;
Figure **14A** is a sectional view of the structure of Example 15 of the present invention;

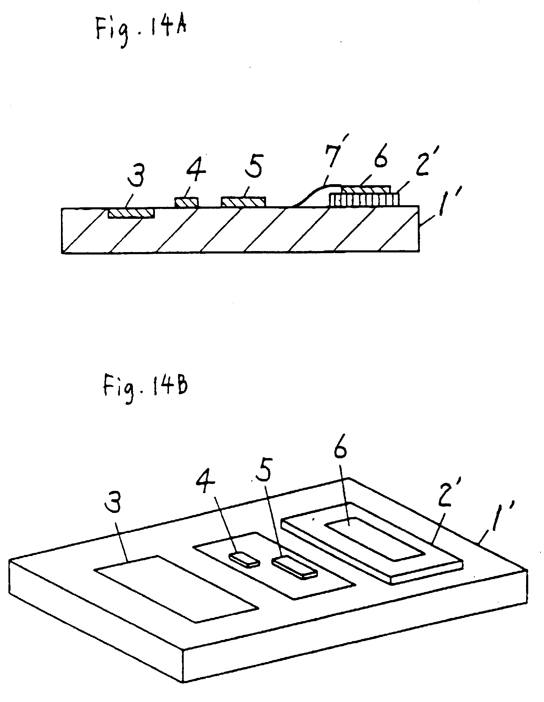

Figure **14B** is a perspective view of the structure of Example 15 of the present invention;

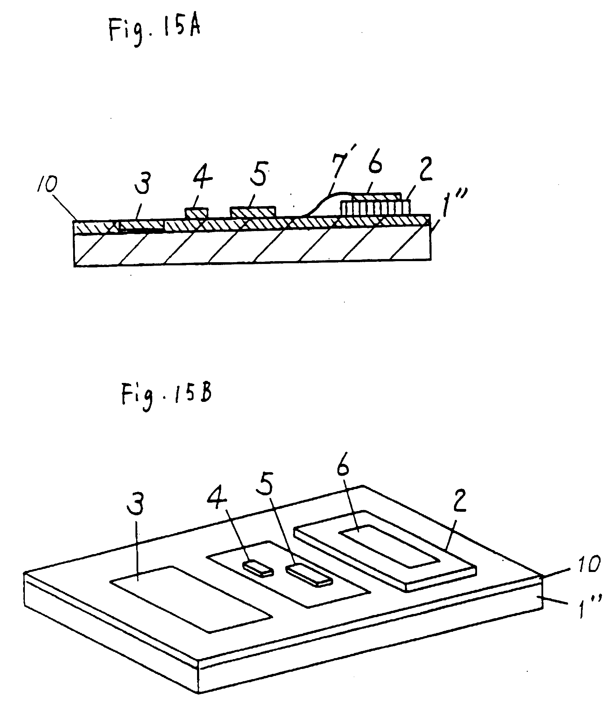

Figure **15A** is a sectional view of the structure of Example 17 of the present invention;
Figure **15B** is a perspective view of the structure of Example 17 of the present invention;

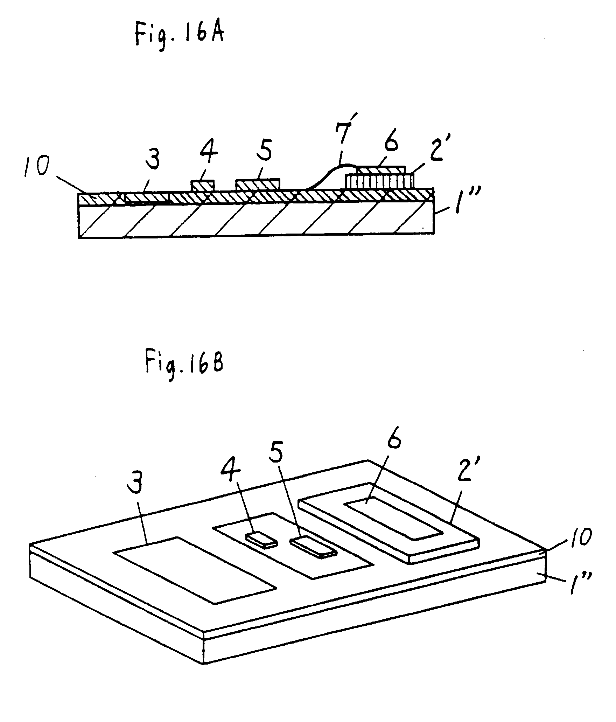

Figure **16A** is a sectional view of the structure of Example 19 of the present invention;
Figure **16B** is a perspective view of the structure of Example 19 of the present invention;

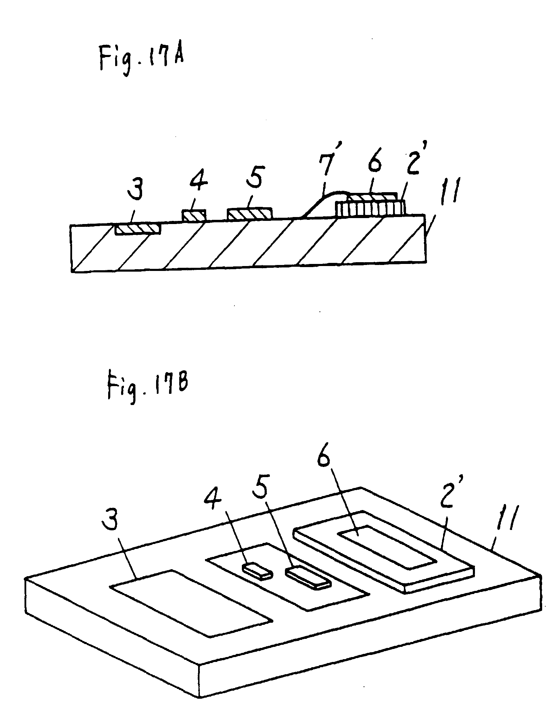

Figure **17A** is a sectional view of the structure of Example 21 of the present invention;
Figure **17B** is a perspective view of the structure of Example 21 of the present invention;
Figure **18A** is a sectional view of the structure of Example 23 of the present invention for the states of NL and SE ;
Figure **18B** is a perspective view of the structure of Example 23 of the present invention for the states of NL & SE ;

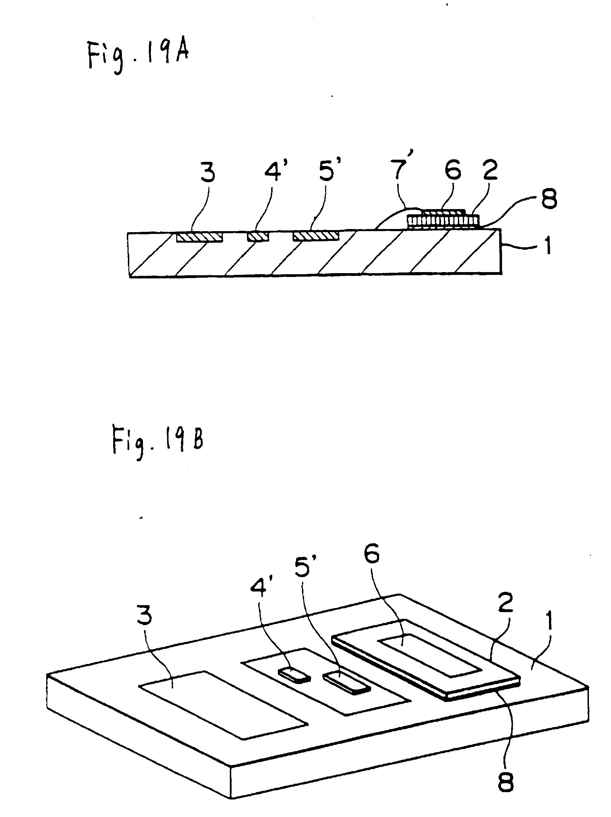

Figure **19A** is a sectional view of the structure of Example 24 of the present invention for the states of NL & SE ;
Figure **19B** is a perspective view of the structure of Example 24 of the present invention for the states of NL & SE ;

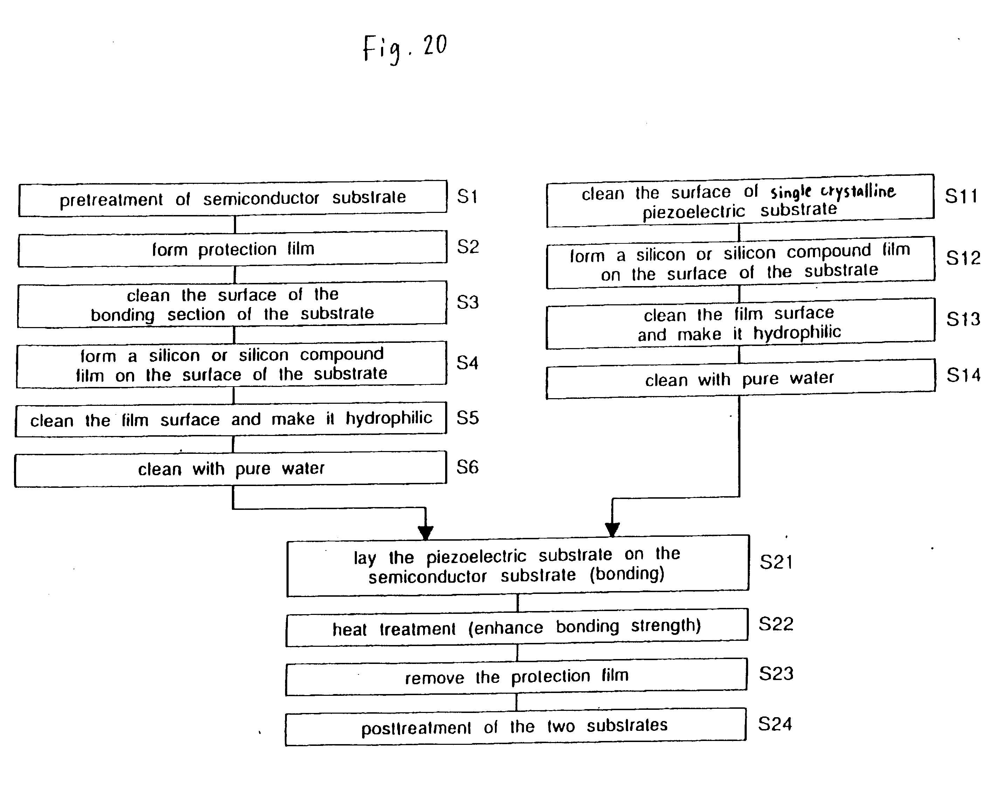

Figure **20** is a flowchart of the manufacturing method of an electro-acoustic hybrid integrated circuit of Example 25 of the present invention for the states of NL & SE ;

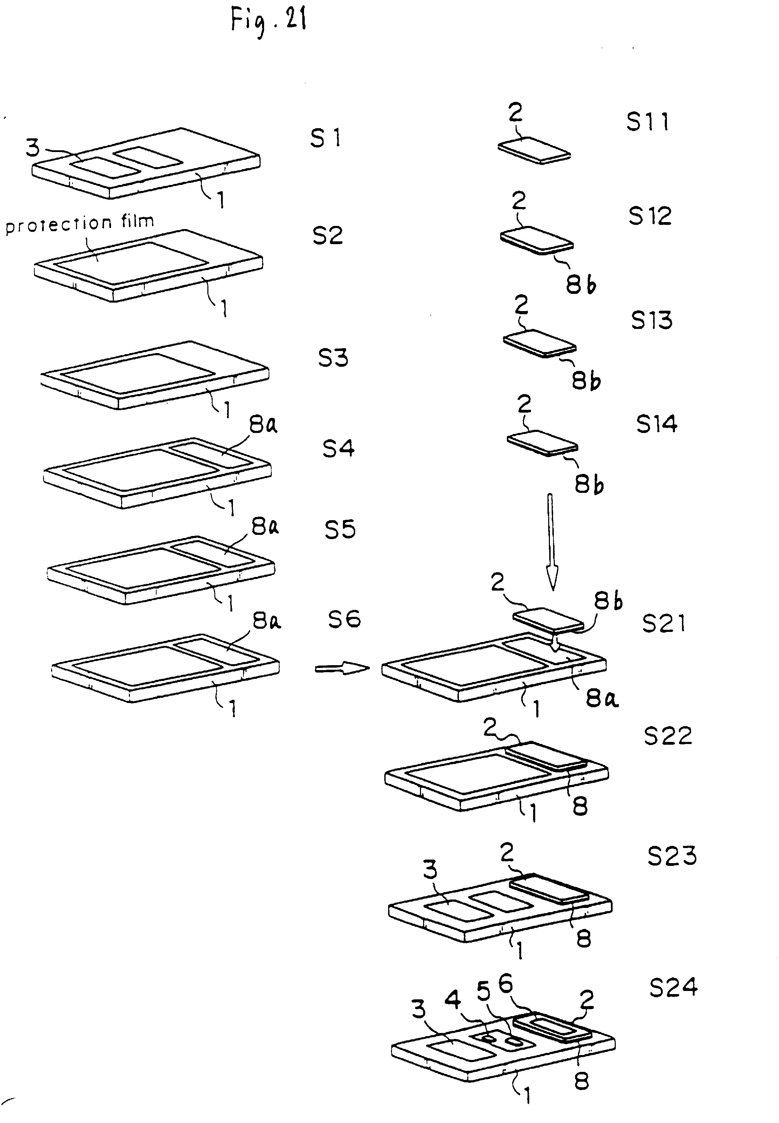

Figure **21** illustrates the manufacture flow chart of Example 25 of the present invention for the states of NL & SE ;

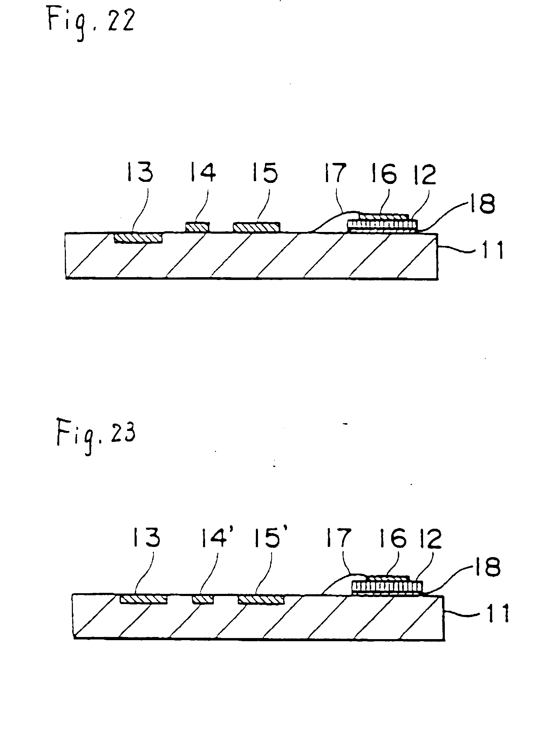

Figure **22** is a sectional view of the structure of Example 27 of the present invention for the states of NL & SE ;
Figure **23** is a sectional view of the structure of Example 28 of the present invention for the states of NL & SE ;

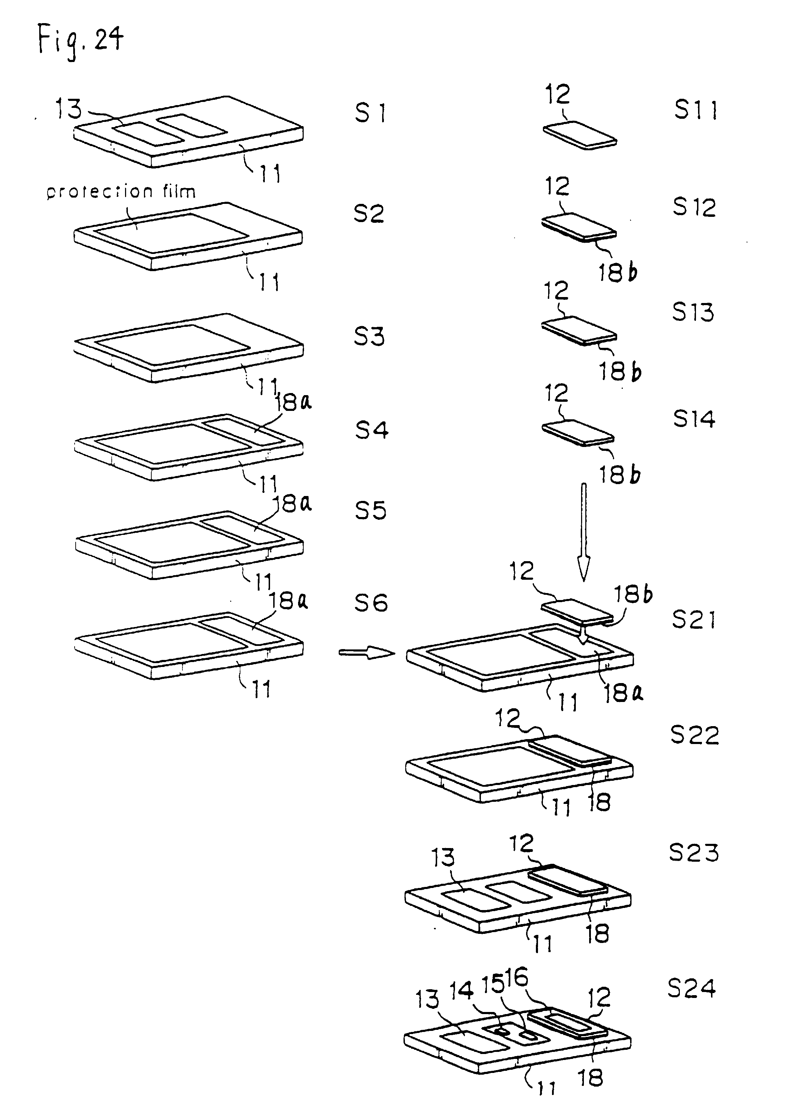

Figure **24** illustrates the manufacture flow chart of Example 29 of the present invention for the states of NL and SE ;
Figure **25A** is a sectional view of the structure of Example 31 of the present invention for the states of NL and SE ;

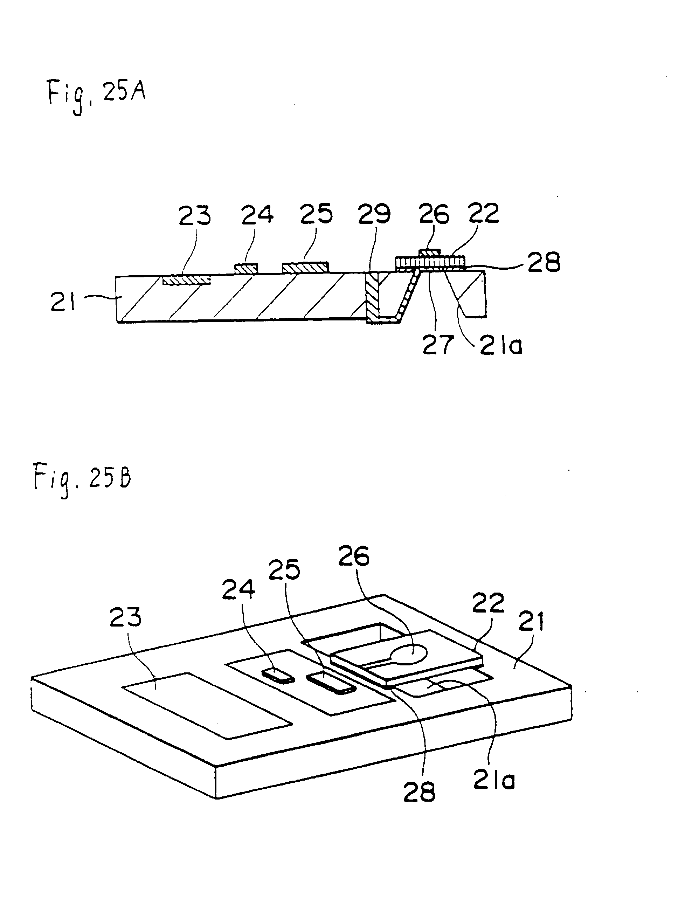

Figure **25B** is a perspective view of the structure of Example 31 of the present invention for the states of NL and SE ;

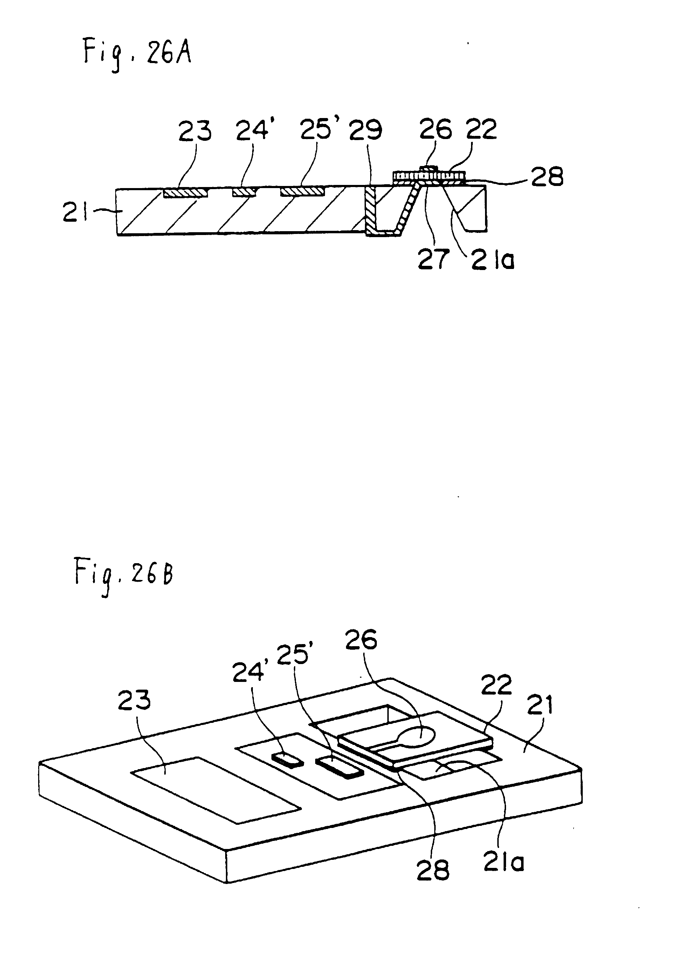

Figure **26A** is a sectional view of the structure of Example 32 of the present invention for the states of NL and SE ;
Figure **26B** is a perspective view of the structure of Example 32 of the present invention for the states of NL and SE ;

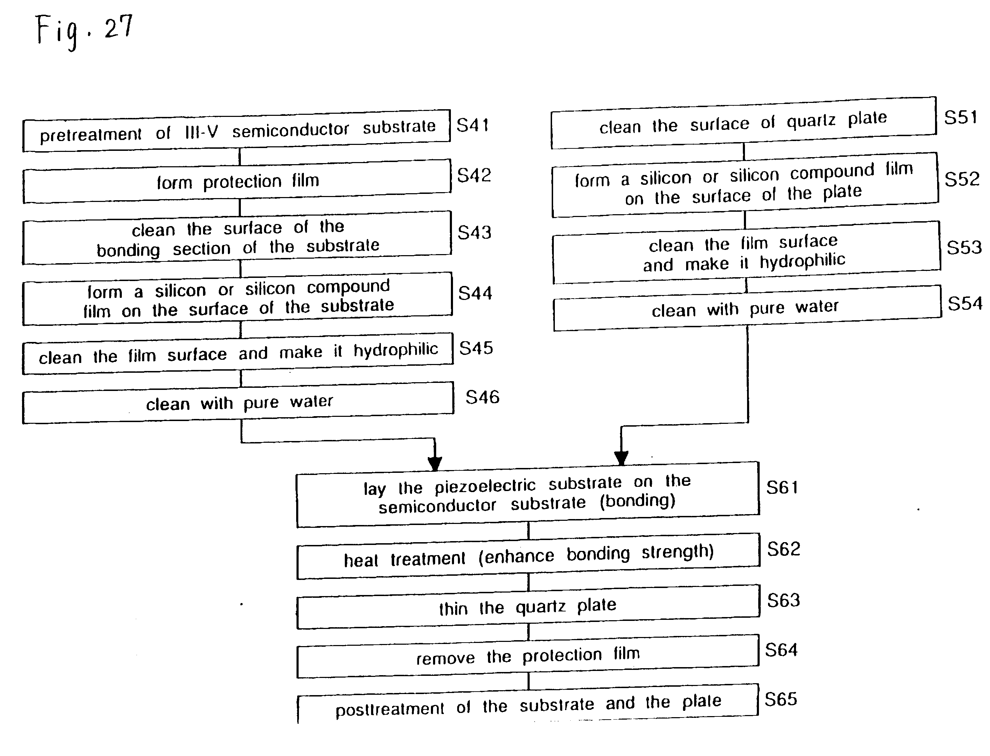

Figure **27** is a flowchart of the manufacturing method of an electro-acoustic hybrid integrated circuit of Example 33 of the present invention for the states of NL and SE ;

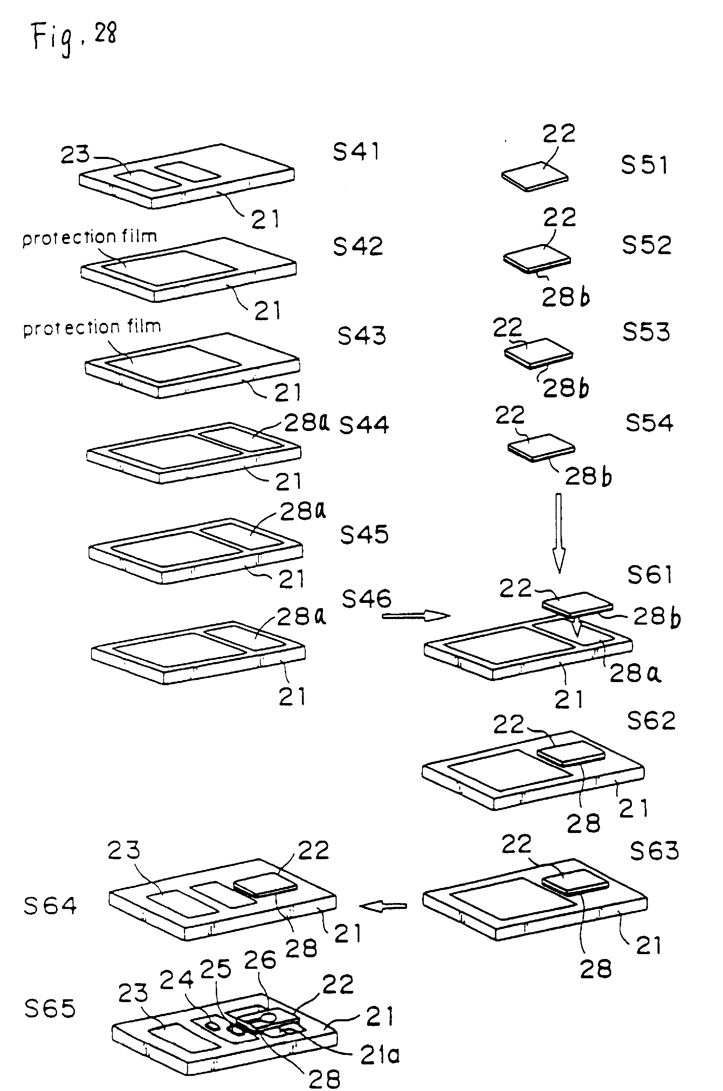

Figure **28** illustrates the manufacture flow chart of Example 34 of the present invention for the states of NL and SE ; and

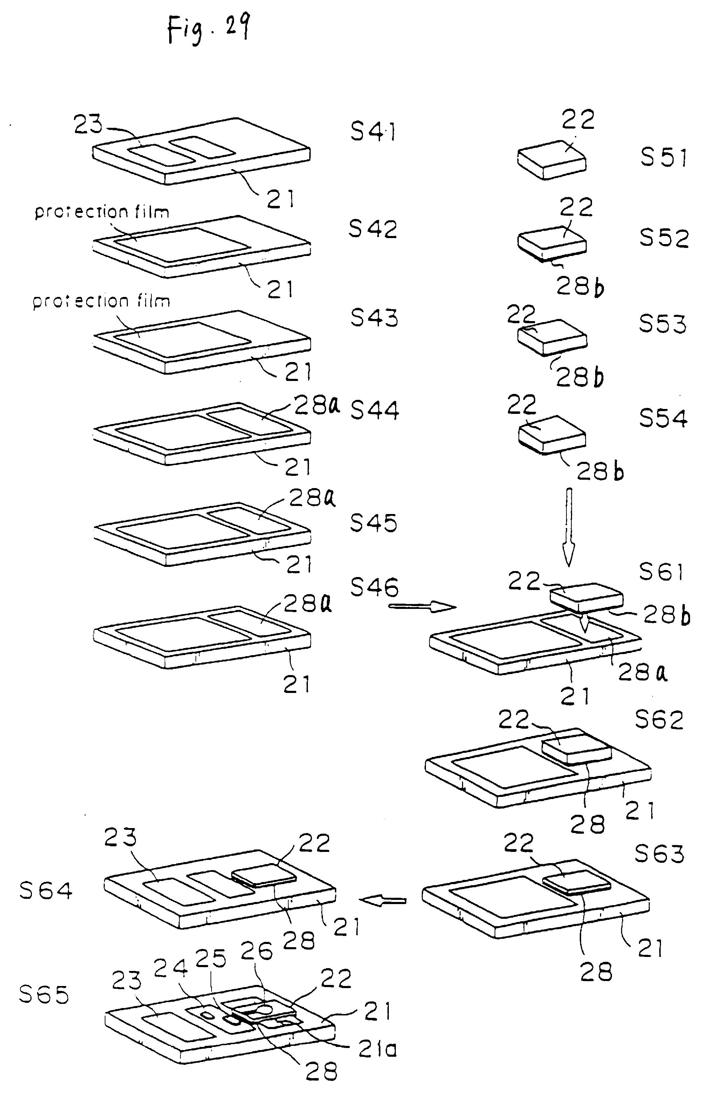

Figure **29** illustrates the manufacture flow chart of Example 35 of the present invention for the states of NL and SE.

### DESCRIPTION OF THE PREFERRED EMBODIMENTS

The electro-acoustic integrated circuits of the present invention, especially when applied to an oscillator and a high frequency amplifier, and methods for manufacturing such electro-acoustic integrated circuits will be described by way of example with reference to the attached drawings as follows:

### Example 1

A voltage controlled oscillator according to a first example of this invention is cross-sectionally shown in Figure **6**. In Figure **6**, the reference number **1** indicates a semiconductor substrate made, for example, of silicon, **2** indicates a quartz crystal resonator bonded through direct bonding onto the semiconductor substrate **1**, **3** indicates a field effect transistor (FET) formed on the semiconductor substrate **1**, **4** indicates a variable capacitance diode chip, **5** indicates a passive chip component part such as a capacitor, an inductor, a resistor and the like, **6** indicates an upper electrode of the quartz crystal resonator **2** and **7** indicates a lower electrode of the quartz crystal resonator **2**. The electrical connection of the lower electrode of the resonator and the wiring formed on the semiconductor substrate is made through such a via-hole method that a hole is perforated through the substrate and filled with an electroconductive material thereby electrically connecting the lower electrode to the wiring on the substrate. The component parts formed on the semiconductor substrate and the upper and lower electrodes of the quartz crystal resonator are respectively electrically connected so as to make a voltage controlled oscillator. Such a voltage controlled oscillator as is integrated in a unitary body as shown above is sealingly contained in a container for keeping its environment resistant performance stable. The field effect transistor, the various electrical component parts and the quartz crystal resonator constitute an oscillator. By varying the voltage to be applied to the variable capacitance diode, the capacitance thereof can be varied, and the oscillation frequency can be varied. By structuring as shown above, the oscillation circuit section and the quartz crystal resonator can be integrated into a unitary body, so that it is possible to make the size outstandingly small as compared with conventional ones. In addition, as compared with conventional ones having a quartz crystal resonator sealing contained into a container individually provided, the apparatus of the invention can be reduced to about one-tenth on a volume basis and to about one-fifth on a weight basis.

The word "direct bonding" is used because no other materials, such as organic adhesives, are used to bond two surfaces of two inorganic plates. The direct bonding can be formed between two hydrophilic surfaces of inorganic materials.

The mechanism of the direct bonding is considered as follows. Hydrophilic surfaces of inorganic materials have surface hydroxyl groups. The number of the surface hydroxyl groups depend on the materials and the surface treatment. In order to introduce a sufficient number of hydroxyl groups to surfaces, a hydrophilic treatment is effective.

The surface hydroxyl groups and chemically adsorbed water molecules thereon form hydrogen bonds between the two surfaces. Subsequent heat treatment cause a desorption of the chemically adsorbed water molecules and condensation reaction of the hydrogen bonded hydroxyl groups which results, in covalent bonds. As a result of the formation of the covalent bonds, the strength of the direct bonding between the two surfaces is improved.

Figures **5A** to **5C** illustrate the mechanism of the formation of the direct bonding schematically. Figure **5A** illustrates the direct bonding immediately after it is formed. When two inorganic plates are superposed with their hydrophilic surfaces facing each other. The surface hydroxyl groups of the two surfaces form hydrogen bonds. Chemically adsorbed water molecules may bridge the hydroxyl groups through hydrogen bonds. Through the hydrogen bonds the two surfaces are bonded together.

Figure **5B** illustrates the direct bonding after a heat treatment at a relatively low temperature, for example 100-500°C. The heat treatment causes desorption of the adsorbed water molecules. Therefore, the surface hydroxyl groups of one surface form hydrogen bonds directly with those of another surface.

Figure **5C** illustrates the direct bonding after a heat treatment at a relatively high temperature, for example above 700°C. The heat treatment causes desorption of the adsorbed water molecules and condensation reactions between the hydrogen bonded hydroxyl groups. Then, the hydrogen bonds result in covalent bonds, which have higher strength than the hydrogen bonds.

The strength of the direct bonding between two surfaces depend on the density of the surface hydroxyl groups and the value of the dipole moment of the hydroxyl groups. Therefore, the strength of the direct bonding highly depend on surface treatments and materials. Moreover, the temperature at which the condensation reactions of the hydroxyl groups take place also depends on the materials.

According to the present invention, hydrophilic treatments may introduce sufficient numbers of surface hydroxyl groups on the surface of a semiconductor substrate and a piezoelectric substrates so as to form direct bonding. As for the surfaces of silicon or quartz, they may have a sufficient number of surface hydroxyl groups such as surface silanols, without a hydrophilic treatment. Because of the nature of the surface of silicon or quartz, deposition of silicon containing compounds on a semiconductor or a piezoelectic substrate improves the strength of the direct bonding. Moreover, the direct bonding of the quartz and silicon is considered to be caused also by a mechanism similar to the direct bonding mechanism, that is, silicon-to-slicon direct bonding, which was revealed by M. Shimbo and others in their report titled as "Silicon Direct Bonding Method", Journal of Applied Physics, Vol. 60 (1986), pp. 2987 to 2989. In other words, the bonding is considered to be taken place at such an atomic level that by the heat treatment, oxygen and silicon atoms on the surface of the quartz crystal, which is a single crystal silicon oxide, are bonded mutually with silicon atoms on the surface of the silicon substrate.

Furthermore, the structure of a surface is very complicated and is not very well known. Therefore, there should be mechanisms other than those mentioned above for the formation of the direct bonding.

If the bonding is made with a bonding material to be used as a general resin or the like, there may arise a problem that various fine processings such as the formation of electrodes and the like to be carried out thereafter cannot be performed. In this case, however, if the method according to this invention is used, the semiconductor substrate and the quartz crystal (single crystal of silicon oxide), particularly when silicon is used as the semiconductor substrate, are bonded to each other through direct bonding. As a result, such a problem does not arise in case that the bonding is made between inorganic substrate and an organic resin, because this invention uses direct bonding between inorganic materials. In case of using a resin binder, there exists a large difference between the thermal expansion coefficient of a resin, which is an organic material, and that of a semiconductor substrate, which is an inorganic material, so that there may arise problems on reliability of oscillator over a long period of time due to thermal stress and thermal stability of the resin itself to be used. On the other hand, this invention bonds it directly onto the semiconductor substrate, so that such problems could be overcome.

### Example 2

Figure **7** is a schematically cross-sectional view of a voltage controlled oscillator according to a second example of this invention. In Figure **7**, **1** is a semiconductor substrate made, for example, of silicon, **2** is a quartz crystal resonator bonded through direct bonding onto the semiconductor substrate **1, 3** is a field effect transistor (FET) formed on the semiconductor substrate, **4**' is a variable capacitance diode whose capacitance can be varied by varying voltage, **5'** is a passive chip component part such as a capacitor, an inductor, a resistor and the like, **6** is an upper electrode of the quartz crystal resonator **2**, and **7** is a lower electrode of the quartz crystal resonator **2**. The upper and lower electrodes of the quartz crystal resonator and the component parts formed on the semiconductor substrate are respectively electrically connected so as to make a voltage controlled oscillator. The voltage controlled oscillator thus integrated in a unitary body is sealingly contained into a container. This example is different from the first example in that the variable capacitance diode **4'** and the passive chip component part **5'** are embeddedly formed into the semiconductor substrate to make a unitary body. The variable capacitance diode is easy to be formed integratedly with the semiconductor substrate when the substrate is made of silicon. In addition, referring to the passive chip component part **5'**, the resistor can be easily obtained as a semiconductor resistor, a thin film resistor of tantalum nitride or the like formed by a diffusion method, the capacitor could be easily formed as a silicon oxide thin film, and the inductor could be easily obtained by forming the wiring pattern in a spiral form. As a result, the oscillator of this example can be more easily compactized than that of the first example, and there does not need to take a time for packaging chip component parts, resulting in an ease in mass-production.

### Example 3

Figure **8** schematically cross-sectionally shows a voltage controlled oscillator according to a third example of this invention, in which **1** is a semiconductor substrate, **2** is a quartz crystal resonator bonded through direct bonding onto the semiconductor substrate **1, 3'** is a bipolar transistor formed on the semiconductor substrate **1, 4'** is a variable capacitance diode chip whose capacitance can be varied by voltage, **5'** is passive chip component part such as a capacitor, an inductor, a resistor and the like, **6** is an upper electrode of the quartz crystal resonator, and **7** is a lower electrode of the quartz crystal resonator. The oscillator of this example is different from those of the first and second examples in that the active element is the bipolar transistor **3'** formed on the semiconductor substrate.

The upper and lower electrodes of the quartz crystal resonator thus formed are electrically connected as to make a voltage controlled oscillator. In addition, the voltage controlled oscillator thus integrated in a unitary body was sealingly contained into a container. With the oscillator thus obtained, the same effects as those in the first and second example can be obtained. Example 3 is different from Example 2 only using a field effect transistor **3** instead of a bipolar transistor **3'** in Example 2.

### Example 4

A production method of a voltage controlled oscillator according one example of this invention will be described below as a fourth example.

First, a silicon semiconductor substrate is subjected to fine processes including a semiconductor process, which are to be carried out at a temperature of 570°C or more, at predetermined positions. For example, a FET and a variable capacitance diode were formed at their predetermined positions by a diffusion processing method or the like, which is carried out at a temperature as high as 1000°C or more in general. Next, a quartz crystal resonator is superposingly placed on the semiconductor substrate thus processed and heated at 560°C or less, thereby bonding the quartz to the silicon. In order to etch the substrate only in a part of area beneath the quartz crystal resonator leaving an area necessary for holding the resonator, the remaining area is covered by applying a photoresist or the like and then, subjected to an etching process, thus removing only the silicon in the part of the area beneath the resonator except the area necessary for holding the resonator. Next, the semiconductor processes including the formation of electrodes are carried out, then or thereafter, an electrode is formed on each of the both surfaces of the quartz crystal resonator by a vacuum deposition method or the like, and wiring is patterned by a generally used photolithographic method. Referring to the heating temperature, for example, at a temperature of 500°C, the bonding is made possible by holding it for about ten minutes at that temperature. If it exceeds 560°C, the crystal structure of quartz is changed, and the performance of a quartz crystal resonator cannot be obtained as predetermined. As a result, the heating temperature for bonding is required to be 560°C or less. Even at a comparatively low temperature, the direct bonding is made possible, for example, even at a temperature as low as 300°C, when held for about one hour at that temperature, the bonding strength at a sufficient level is obtained. As a result, as the heat treatment temperature for the direct bonding, it is preferable for the heat to range from 300°C to 500°C.

### Example 5

Another production method of a voltage controlled oscillator according to one example of this invention will be described below as a fifth example.

As in the fourth example, first, a silicon semiconductor substrate is subjected to such semiconductor processes as to be carried out at a temperature of 570°C or more at the predetermined positions. For example, a FET and a variable capacitance diode are formed at their predetermined positions by a diffusion processing method or the like. Then, a quartz crystal resonator is superposingly placed on the silicon semiconductor substrate thus processed and heated thereby bonding the quartz of the resonator and the silicon of the substrate through direct bonding. Thereafter, the quartz crystal resonator thus bonded is thinned by a polishing or etching method. By applying this method, a quartz crystal resonator having an initial thickness of about 200 µm is easily thinned to a thickness of 5 µm or less. By further applying a fine etching method thereto, it can be further thinned, thus even a thickness as small as 1 µm can be realized. In case of using quartz crystal AT cut, if it is about 1 µm thick, a fundamental wave oscillation is made possible at a frequency level of about 1 to 2 GHz. Next, by applying the same processes as in the fourth example, it is made possible to produce a voltage controlled oscillator having the semiconductor substrate and the quartz crystal resonator integrated in a unitary body with each other. With the voltage controlled oscillator thus produced, the fundamental wave mode is made possible at such a high-frequency level of 2 GHz as not to be obtainable conventionally.

### Example 6

Yet another production method of a voltage controlled oscillator according to one example of this invention will be described below as a sixth example.

As in the fourth example, first, a silicon semiconductor substrate is subjected to such semiconductor processes as to be carried out at a temperature of 570°C or more at the predetermined position. Next, the silicon and a quartz crystal resonator are directly bonded to each other under the application of a heat and pressure. The quartz crystal resonator can be bonded thereto by the gravitational effect of its own weight, however, the bonding strength could be improved by applying a pressure at a level of 100 g/cm² to 10 kg/cm² by a method where a sufficient weight is placed at the area to be bonded to each other. Next, as in the fifth example, the quartz crystal resonator is thinned by a polishing or etching method as desired. Then, by applying the same processes as in the fourth embodiment, it is made possible to produce a voltage controlled oscillator having the semiconductor substrate and the quartz crystal resonator integrated in a unitary body with each other as well as to obtain the same effects as obtained in the fourth example.

### Example 7

Another production method of a voltage controlled oscillator according one example of this invention will be described below as a seventh example.

As in the fourth example, first, a silicon semiconductor substrate is subjected to semiconductor processes at the predetermined positions. Next, the surface of the silicon substrate and the surface of a quartz crystal resonator are thoroughly cleaned. That is, each of them is repeatedly boiled with an organic solvent in order to remove any contaminants on the surface. Next, the silicon substrate is subjected to a hydrophilic treatment with a solution of ammonia and hydrogen-peroxide. The quartz crystal resonator is subjected to removal of the surface layer with an etching solution of the hydrofluoric acid system. Then, both the surfaces are rinsed with pure water and superposed uniformly as soon as possible after rinsing, thus both are capable of direct bonding to each other easily. Next, the quartz crystal resonator is thinned by applying a polishing or etching method as desired in the same way as in the fifth example. Thereafter, by being subjected to the same processes as in the fifth example, a voltage controlled oscillator having the semiconductor and the quartz crystal resonator integrated in a unitary body with each other is made possible to be produced, thus being obtainable the same effects as those in the fourth and fifth examples. The production method shown in this example allows the bonding to be carried out at room temperature. As a result, it can be carried out after all processes have been performed. In this case, it is considered that the silicon substrate and the quartz crystal resonator are bonded to each other through hydrogen bonds between the hydroxyl groups of the silicon surface and the quartz surface, which means that the surface treatment of the substrate is extremely important. In addition, by further heat-treating the specimen thus bonded at a temperature of 560°C or less, the bonding strength can be further improved.

### Example 8

Figures **9A** and **9B** are a side view and a perspective view, respectively, of an oscillator as a eighth example of the present invention. Referring to Figures **9A** and **9B**, the reference numeral **1** denotes a substrate made of GaAs, a III-V group compound semiconductor. The reference numeral **2** denotes a single crystalline piezoelectric substrate or a quartz crystal substrate which constitutes a surface acoustic wave resonator. The quartz crystal substrate **2** is bonded through direct bonding to the GaAs substrate **1**. The reference numeral **3** denotes a transistor formed on the GaAs substrate **1**. Varactor diodes **4** having an electrostatic capacitance varying with the applied voltage, and passive chip components **5** such as capacitors, inductors, and resistors are mounted on the GaAs substrate **1**. Comb-type electrodes **6** are provided on the quartz crystal substrate **2** to form the surface acoustic wave resonator, and wires **7**' connect the electrodes **6** with interconnections formed on the GaAs substrate **1**.

Figures **9A** and **9B** schematically illustrate a typical arrangement of the above-described components. In an actual implementation, the arrangement of the components and the connection of electrodes are properly determined so that a voltage controlled oscillator having a circuit configuration shown in Figure **1** can be obtained.

The varactor diode **4** and the passive chip components **5** such as capacitors and resistors may be incorporated in the GaAs substrate **1**. Also, a metal thin film may be formed on the GaAs substrate **1** as wirings instead of the wires **7**'.

By varying the voltage applied to the varactor diodes **4**, the electrostatic capacitance of the varactor diodes **4** and thus the oscillation frequency can be varied.

The GaAs substrate **1** and the quartz crystal substrate **2** are bonded without any organic bonding agent therebetween. Such an integrated structure is then sealed in a container. The thus-obtained voltage controlled oscillator can be made significantly smaller than the conventional one in which the substrates are integrated after having been sealed separately. In practice, it is easy to reduce the volume of the oscillator to about a tenth and the weight thereof to about a fifth the conventional oscillator in which the surface acoustic wave resonator is first sealed in a container before being integrated.

The direct bonding has other advantages. If the semiconductor substrate and the single crystalline piezoelectric substrate are bonded to each other with an ordinary bonding agent made of resin or the like, the subsequent semiconductor process after the bonding is not possible because such a bonding agent is not durable against high temperature and chemicals. However, according to this example where the GaAs substrate **1** and the quartz crystal substrate **2** are directly bonded, such a problem can be greatly alleviated.

Further, if a bonding agent made of resin or the like is used, the parallelization of the GaAs substrate and the quartz crystal substrate attached thereto is not satisfactory. This results in lowering the accuracy of the size of the comb-type electrodes **6** to be formed on the quartz crystal substrate in a later photolithographic process. For example, in order to obtain a resonance frequency in the order of 1 GHz, the electrodes **6** should have a width of a micron or less. Under this condition, if a satisfactory parallelization is not obtained, a surface acoustic wave resonator for a submicrowave band cannot be formed. According to this example, however, since the GaAs substrate **1** and the quartz crystal substrate **2** are directly bonded, the parallelization thereof is determined only by the accuracy of the surface finish of the substrates which can be sufficiently enhanced. Thus, the above-described problem can be prevented. This is especially effective when a high resonance frequency is required.

Other problems arising when a bonding agent made of resin is used include inferior heat resistance and inferior long-term reliability. The latter is due to the thermal strain caused because the thermal expansion coefficient of the organic resin greatly differs from that of the GaAs substrate and the quartz crystal substrate both of which are inorganic. These problems can also be prevented according to this example.

Though the oscillator having the circuit configuration shown in Figure **1** is described in this example, it is needless to say that oscillators having other circuit configurations can also be integrated as described above.

Since the electron mobility of the GaAs substrate is about six times as high as that of an Si substrate, a high frequency transistor can be easily fabricated on the GaAs substrate. Accordingly, the GaAs substrate is especially suitable for the manufacture of a high frequency circuit having, especially, a frequency of 1 GHz or more.

Though, the surface acoustic wave resonator is formed as the electro-acoustic element in this example, a bulk acoustic wave element can also be formed.

Quartz as the electro-acoustic element has an electromechanical coupling coefficient (the coefficient corresponding to the rate of the conversion of the electric energy to the mechanical energy) of 0.2%, the smallest among those of lithium niobate, lithium tantalate, and lithium borate. However, quartz has a crystal orientation where the dependence of the resonance frequency upon the temperature is zero (i.e., the resonance frequency does not vary at all in the range of temperatures actually used). Such a crystal orientation can be found, for example, in a crystal cut called an AT cut. Moreover, quartz can obtain the highest value of Q (the value corresponding to the inverse of an energy loss at resonance). In practice, it is easy to obtain a value Q of 20000 or more. With these properties, quartz can be used for a temperature compensated oscillator which is temperature-independent, a high frequency device which requires a filter having an extremely narrow specific bandwidth (the ratio of the center frequency in the pass band to the pass frequency band) of 0.1% or less, and an oscillator with high accuracy and high stability. According to this example, since the quartz crystal substrate having a desired crystal orientation can be directly bonded to the GaAs substrate, the resultant electro-acoustic element is significantly superior to a piezoelectric thin film formed by a conventional thin-film technique.

### Example 9

Figure **3** is a circuit diagram of a high frequency amplifier as a ninth example of the present invention, in which a filter and an amplifying circuit including a transistor and capacitors are directly connected. Such a high frequency amplifier can be obtained as in Example 8: That is, the electronic elements are formed on a GaAs substrate, while the filter, a surface acoustic wave filter, is formed on a quartz crystal substrate. These components are then connected by wirings so as to obtain the circuit configuration shown in Figure **3**. In this way, the electro-acoustic integrated circuit in which the filter and the amplifying circuit are integrated can be manufactured. Since the GaAs substrate and the quartz crystal substrate are bonded through direct bonding to each other as in Example 8, the same effects as those described in Example 8 can be obtained.

### Example 10

A method for manufacturing the oscillator of Example 8 as a tenth example of the present invention will be described with reference to the manufacture flow chart of Figure **10** as follows:

First, one or more concaves are formed on prescribed areas of the GaAs substrate **1** by etching or the like. Then, a series of semiconductor processes are carried out so that electronic elements such as the transistor **3** and the varactor diodes **4** are formed inside the concaves. The semiconductor processes include processes carried out at a temperature higher than that for the heat treatment required for subsequent direct bonding, such as a diffusion process. The diffusion process is normally performed at 1000°C or more. The areas of the GaAs substrate **1** in which the electronic elements are formed are then covered with a protection film.

Then, the surface of a portion of the GaAs substrate **1** and a surface of the quartz crystal substrate **2** which are to be bonded to each other are sufficiently cleaned. In practice, these surfaces are cleaned with a solvent so as to remove organic substances therefrom, and slightly etched with a hydrofluoric acid. Thereafter, these surfaces are made hydrophilic by the treatment with a solution of ammonia-hydrogen peroxide at 60-70°C. The treated surfaces are then sufficiently rinsed with pure water, and uniformly attached to each other. In this way, the two substrates can be easily bonded.

The bonded substrates are then subjected to the heat treatment to enhance the bonding strength. The bonding strength can be enhanced when the heat treatment is performed at 100-800°C. For example, the bonding strength increases several times by maintaining the temperature of 200°C for one hour. As a result, the strength of several tens of kilograms per cm² can be obtained. With the temperature increase, As tends to evaporate from the GaAs substrate. Such evaporation of As should is preferably minimized by covering GaAs substrate with a GaAs wafer or any other means.

In principle, as the temperature for the heat treatment is higher, the quartz crystal substrate should be thinner in thickness and smaller in size, so that the bonding strength can be improved without causing troubles of pealing off and breakage, though the shape and size of the quartz crystal substrate may be a little restricted because the thermal expansion of the GaAs substrate is different from that of the quartz crystal substrate.

Next, a series of processes including the electrode formation process are carried out at a temperature lower than that for the heat treatment required for the direct bonding. During or after these processes, electrodes are formed on the exposed surface of the quartz crystal substrate by vacuum vapor deposition or the like, and then wiring patterns are formed by a normal photolithographic method. Aluminum or gold is used for the electrodes.

The above manufacturing method for the oscillator is also applicable to the manufacture of a high frequency amplifier in which a filter is used as the electro-acoustic element and the circuit configuration is a little different from that of the oscillator.

Though the above manufacturing method is for a circuit using a surface acoustic wave resonator or filter as the electro-acoustic element, the method is also applicable to a circuit using a bulk acoustic wave element as the electro-acoustic element. In this case, a portion of the semiconductor substrate beneath the bulk acoustic wave element is hollowed out by etching or the like after the heat treatment for bonding.

### Example 11

Figures **11A** and **11B** are a side view and a perspective view, respectively, of an oscillator as an eleventh example of the present invention. Referring to Figures **11A** and **11B**, the reference numeral **1** denotes a substrate made of GaAs, a III-V group compound semiconductor. The reference numeral **2**' denotes a single crystalline piezoelectric substrate made of material selected from the group consisting of lithium niobate, lithium tantalate, and lithium borate, which constitutes a surface acoustic wave resonator. The single crystalline piezoelectric substrate **2'** is bonded through direct bonding to the GaAs substrate **1**. The other reference numerals **3** to **7'** denote the same components as those described in Example 8, and the description thereof is omitted here.

Figures **11A** and **11B** schematically illustrate a typical arrangement of the above-described components. As in Example 8, in an actual implementation, the arrangement of the components and the connection of electrodes are properly determined so that a voltage controlled oscillator having a circuit configuration shown in Figure 1 can be obtained.

The varactor diodes **4** and the passive chip components 5 such as capacitors and resistors may be incorporated in the GaAs substrate **1**.

The GaAs substrate **1** and the single crystalline piezoelectric substrate **2**' are bonded through direct bonding by attaching the surfaces of the two substrates to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure **1** is described in this example, it is needless to say that oscillators having other circuit configurations can also be integrated as described above.

Since the electron mobility of the GaAs substrate is about six times as high as that of an Si substrate, a high frequency transistor can be easily fabricated on the GaAs substrate. Accordingly, the GaAs substrate is especially suitable for the manufacture of a high frequency circuit.

The structure of this example is also applicable to a high frequency amplifier having the circuit configuration shown in Figure **3** as described in Example 9. The same effects as those described above are also obtained by this application.

Lithium niobate has a large electromechanical coupling coefficient, which is in the range of 5% (128°, Y-cut, crystal orientation of X-axis propagation) to 17% (64°, Y-cut, X-axis propagation). Lithium niobate is therefore suitable for a resonator or a filter which has a high frequency, a low energy loss, and a wide bandwidth (specific bandwidth: 2-5%). In practice, it is used for a circuit including a resonator type RF filter or a band-pass filter, a voltage controlled oscillator having a wide bandwidth, and the like used, for example, for a portable telephone having a band in the range of 800 MHz to 1.9 GHz.

Lithium tantalate has an intermediate-level electromechanical coupling coefficient, which is 0.75-5% (36°, Y-cut, X-axis propagation). Lithium tantalate has a temperature dependence (18-32 ppm) superior to that of lithium niobate (50-100 ppm). In practice, it is used for a circuit including a RF filter or a band-pass filter which has a high frequency, a low energy loss, and an intermediate bandwidth (specific bandwidth: 1-2%), a voltage controlled oscillator having an intermediate bandwidth, and the like.

Lithium borate has an electromechanical coupling coefficient of 1% which is larger than that of quartz (0.2%), while having a crystal orientation where the temperature dependence is zero. Accordingly, lithium borate is used for a filter or an oscillator which has high precision, high stability, and an intermediate bandwidth. Since lithium borate can be easily etched with a low-concentration alkaline solution, it has following advantages: first, a substrate made of lithium borate can be etched to form an ultrathin sheet having a thickness of 10 µm or less after the bonding thereof to a semiconductor substrate without damaging the semiconductor substrate. Secondly, lithium borate is suitable for forming an electro-acoustic element having a complicated shape, such as a tuning fork.

The single crystalline piezoelectric substrate **2**' of this example can be made of either of the above materials having a desired crystal orientation. Accordingly, an excellent electro-acoustic element can be realized by this example compared with conventional piezoelectric thin films formed by various thin-film techniques.

### Example 12

A method for manufacturing the oscillator of Example 11 as a twelfth example of the present invention will be described with reference to the manufacture flow chart of Figure **12** as follows:

The manufacturing process of this example is basically the same as that described in Example 10, except that the quartz substrate **2** in Example 10 is replaced with the single crystalline piezoelectric substrate **2**' made of material selected from the group consisting of lithium niobate, lithium tantalate, and lithium borate. The single crystalline piezoelectric substrate **2**' can also be bonded through direct bonding to the GaAs substrate **1** by the hydrophilic treatment, the rinse with pure water, and the heat treatment after the attachment of the surfaces as described in Example 10. Necessary electronic circuits and wirings are also formed as described in Example 10. The temperature for the heat treatment can also be in the range of 100-800°C, so as to obtain favorable direct bonding.

The above manufacturing method for the oscillator is also applicable to the manufacture of a high frequency amplifier in which a filter is used as the electro-acoustic element and the circuit configuration is a little different from that of the oscillator. Further, a bulk acoustic wave element can also be formed as the electro-acoustic element as described in Example 10.

### Example 13

Figures **13A** and **13B** are a side view and a perspective view, respectively, of an oscillator as a thirteenth example of the present invention. Referring to Figures **13A** and **13a**, the reference numeral **1**' denotes a substrate made of InP, a III-V group compound semiconductor. The reference numeral **2** denotes a single crystalline piezoelectric substrate or a quartz crystal substrate which constitutes a surface acoustic wave resonator. The quartz substrate **2** is bonded through direct bonding to the InP substrate **1**'. The other reference numerals **3** t**o 7**' denote the same components as those described in Example 1, and the description thereof is omitted here.

Figures **13A** and **13B** schematically illustrate a typical arrangement of the above-described components. As in Example 8, in an actual implementation, the arrangement of the components and the connection of electrodes are properly determined so that a voltage controlled oscillator having a circuit configuration shown in Figure **1** can be obtained.

The varactor diodes **4** and the passive chip components **5** such as capacitors and resistors may be incorporated in the InP substrate **1**'.

The InP substrate **1'** and the quartz crystal substrate **2** are bonded through direct bonding by attaching the surfaces of the two substrates to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure 1 is described in this example, it is needless to say that oscillators having other circuit configurations can also be integrated as described above.

Since the electron mobility of the InP substrate is about twice as high as that of an Si substrate, a high frequency transistor can be easily fabricated in the InP substrate. Accordingly, the InP substrate is especially suitable for the manufacture of a high frequency circuit.

The structure of this example is also applicable to a high frequency amplifier having the circuit configuration shown in Figure **3** as described in Example 9. The same effects as those described above are also obtained by this application.

### Example 14

A method for manufacturing the oscillator of Example 13 as a fourteenth example of the present invention will be described.

The manufacturing process of this example is basically the same as that described in Example 10, except that the GaAs substrate **1** in Example 10 is replaced with the InP substrate **1**'. The InP substrate **1**' can also be bonded through direct bonding with the quartz crystal substrate **2** by the hydrophilic treatment, the rinse with pure water, and the heat treatment after attaching the surfaces as described in Example 10. Necessary electronic circuits and wirings are also formed as described in Example 10. The temperature for the heat treatment can also be in the range of 100-800°C, so as to obtain favorable direct bonding.

The above manufacturing method for the oscillator is also applicable to the manufacture of a high frequency amplifier in which a filter is used as the electro-acoustic element and the circuit configuration is a little different from that of the oscillator.

### Example 15

Figures **14A** and **14B** are a side view and a perspective view, respectively, of an oscillator as a fifteenth example of the present invention. Referring to Figures **14A** and **14B**, the reference numeral **1**' denotes a substrate made of InP, a III-V group compound semiconductor. The reference numeral **2**' denotes a single crystalline piezoelectric substrate made of material selected from the group consisting of lithium niobate, lithium tantalate, and lithium borate, which constitutes a surface acoustic wave resonator. The single crystalline piezoelectric substrate **2**' is bonded through direct bonding to the InP substrate **1**'. The other reference numerals **3** to **7**' denote the same components as those described in Example 8, and the description thereof is omitted here.

Figures **14A** and **14B** schematically illustrate a typical arrangement of the above-described components. As in Example 8, in an actual implementation, the arrangement of the components and the connection of electrodes are properly determined so that a voltage controlled oscillator having a circuit configuration shown in Figure **1** can be obtained.

The varactor diodes **4** and the passive chip components **5** such as capacitors and resistors may be incorporated in the InP substrate **1**'.

The InP substrate **1**' and the single crystalline piezoelectric substrate **2**' are bonded through direct bonding by attaching the surfaces of the two substrates to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure **1** is described in this example, it is needless to say that oscillators having other circuit configurations can also be integrated as described above.

Since the electron mobility of the InP substrate is about twice as high as that of an Si substrate, a high frequency transistor can be easily fabricated on the InP substrate. Accordingly, the InP substrate is especially suitable for the manufacture of a high frequency circuit.

The structure of this example is also applicable to a high frequency amplifier having the circuit configuration shown in Figure **3** as described in Example 9. The same effects as those described above are also obtained by this application.

### Example 16

A method for manufacturing the oscillator of Example 15 as a sixteenth example of the present invention will be described.

The manufacturing process of this example is basically the same as that described in Example 10, except that the GaAs substrate **1** in Example 10 is replaced with the InP substrate **1**', and the quartz substrate **2** is replaced with the single crystalline piezoelectric substrate **2**' made of material selected from the group consisting of lithium niobate, lithium tantalate, and lithium borate. The InP substrate **1**' can also be bonded through direct bonding with the single crystalline piezoelectric substrate **2**' by the hydrophilic treatment, the rinse with pure water, and the heat treatment after attaching the surfaces as described in Example 10. Necessary electronic circuits and wirings are also formed as described in Example 10. The temperature for the heat treatment can also be in the range of 100-800°C, so as to obtain favorable direct bonding.

The above manufacturing method for the oscillator is also applicable to the manufacture of a high frequency amplifier in which a filter is used as the electro-acoustic element and the circuit configuration is a little different from that of the oscillator.

### Example 17

Figures **15A** and **15B** are a side view and a perspective view, respectively, of an oscillator as a seventeenth example of the present invention. Referring to Figures **15A** and **15B**, the reference numeral **1**'' denotes a substrate made of GaAs, a III-V group compound semiconductor. The reference numeral **10** denotes an InGaAs layer formed on the GaAs substrate **1"**. The reference numeral **2** denotes a single crystalline piezoelectric substrate or a quartz substrate which constitutes a surface acoustic wave resonator. The quartz crystal substrate **2** is bonded through direct bonding to the InGaAs layer **10.** The other reference numerals **3** to **7'** denote the same components as those described in Example 8, and the description thereof is omitted here.

Figures **15A** and **15B** schematically illustrate a typical arrangement of the above-described components. As in Example 8, in an actual implementation, the arrangement of the components and the connection of electrodes are properly determined so that a voltage controlled oscillator having a circuit configuration shown in Figure **1** can be obtained.

The varactor diodes **4** and the passive chip components **5** such as capacitors and resistors may be incorporated in the GaAs substrate **1"** and the InGaAs layer **10** formed thereon.

The InGaAs layer **10** and the quartz crystal substrate 2 are bonded through direct bonding by attaching the surfaces thereof to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure **1** is described in this example, it is needless to say that oscillators having other circuit configurations can also be integrally formed as described above.

Since the electron mobility of the InGaAs layer, as well as that of the GaAs substrate, is about three to five times as high as that of an Si substrate, a high frequency transistor can be easily fabricated on the InP substrate. Accordingly, the InP substrate is especially suitable for the manufacture of a high frequency circuit.

The structure of this example is also applicable to a high frequency amplifier having the circuit configuration shown in Figure **3** as described in Example 9. The same effects as those described above are also obtained by this application.

### Example 18

A method for manufacturing the oscillator of Example 17 as a eighteenth example of the present invention will be described.

The manufacturing process of this example is basically the same as that described in Example 10, except that the GaAs substrate **1** in Example 10 is replaced with the GaAs substrate **1''** and the InGaAs layer **10** formed thereon. The quartz crystal substrate **2** and the InGaAs layer **10** can also be bonded through direct bonding to each other by the hydrophilic treatment, the rinse with pure water, and the heat treatment after attaching the surfaces as described in Example 10. Necessary electronic circuits and wirings are also formed as described in Example 10. The temperature for the heat treatment can also be in the range of 100-800°C, so as to obtain favorable direct bonding. The electronic elements are formed on the InGaAs layer **10.** The thickness of the InGaAs layer **10** required for the formation of the electronic elements is 1-5 µm.

The above manufacturing method for the oscillator is also applicable to the manufacture of a high frequency amplifier in which a filter is used as the electro-acoustic element and the circuit configuration is a little different from that of the oscillator.

### Example 19

Figures **16A** and **16B** are a side view and a perspective view, respectively, of an oscillator as a nineteenth example of the present invention. Referring to Figures **16A** and **16B**, the reference numeral **1**'' denotes a substrate made of GaAs, a III-V group compound semiconductor. The reference numeral **10** denotes an InGaAs layer formed on the GaAs substrate **1**''. The reference numeral **2**' denotes a single crystalline piezoelectric substrate made of material selected from the group consisting of lithium niobate, lithium tantalate, and lithium borate, which constitutes a surface acoustic wave resonator. The single crystalline piezoelectric substrate **2'** is bonded through direct bonding to the InGaAs layer **10**. The other reference numerals **3** to **7**' denote the same components as those described in Example 8, and the description thereof is omitted here.

Figures **16A** and **16B** schematically illustrate a typical arrangement of the above-described components. As in Example 8, in an actual implementation, the arrangement of the components and the connection of electrodes are properly determined so that a voltage controlled oscillator having a circuit configuration shown in Figure **1** can be obtained.

The varactor diodes **4** and the passive chip components **5** such as capacitors and resistors may be incorporated in the GaAs substrate **1"** and the InGaAs layer **10** formed thereon.

The InGaAs layer **10** and the single crystalline piezoelectric substrate **2**' are bonded through direct bonding by attaching the surfaces thereof to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure **1** is described in this example, it is needless to say that oscillators having other circuit configurations can also be integrated as described above.

Since the electron mobility of the InGaAs layer, as well as that of the GaAs substrate, is about three to five times as high as that of an Si substrate, a high frequency transistor can be easily fabricated on the InP substrate. Accordingly, the InP substrate is especially suitable for the manufacture of a high frequency circuit.

The structure of this example is also applicable to a high frequency amplifier having the circuit configuration shown in Figure **3** as described in Example 9. The same effects as those described above are also obtained by this application.

### Example 20

A method for manufacturing the oscillator of Example 19 as a twentieth example of the present invention will be described.

The manufacturing process of this example is basically the same as that described in Example 10, except that the GaAs substrate **1** in Example **10** is replaced with the GaAs substrate **1''** and the InGaAs layer **10** formed thereon, and the quartz substrate **2** is replaced with the single crystalline piezoelectric substrate **2**' made of material selected from the group consisting of lithium niobate, lithium tantalate, and lithium borate. The single crystalline piezoelectric substrate **2**' and the InGaAs layer **10** can also be bonded through direct bonding to each other by the hydrophilic treatment, the rinse with pure water, and the heat treatment after attaching the surfaces as described in Example 10. Necessary electronic circuits and wirings are also formed as described in Example 10. The temperature for the heat treatment can also be in the range of 100-800°C, so as to obtain favorable direct bonding. The electronic elements are formed on the InGaAs layer **10.** The thickness of the InGaAs layer **10** required for the formation of the electronic elements is 1-5 µm.

The above manufacturing method for the oscillator is also applicable to the manufacture of a high frequency amplifier in which a filter is used as the electro-acoustic element and the circuit configuration is a little different from that of the oscillator.

In the above examples, GaAs, InP and InGaAs were used as the III-V group compound semiconductor for the semiconductor substrate. Other III-V group compound semiconductors which resemble in the chemical and electronic properties to those mentioned above can also be used.

### Example 21

Figures **17A** and **17B** are a side view and a perspective view, respectively, of an oscillator as a twenty first example of the present invention. Referring to Figures **17A** and **17B**, the reference numeral **11** denotes a substrate made of Si. The reference numeral **2**' denotes a single crystalline piezoelectric substrate made of material selected from the group consisting of lithium niobate, lithium tantalate, and lithium borate, which constitutes a surface acoustic wave resonator. The single crystalline piezoelectric substrate **2**' is bonded through direct bonding on the Si substrate **11**. The other reference numerals **3** to **7**' denote the same components as those described in Example 1, and the description thereof is omitted here.

Figures **17A** and **17B** schematically illustrate a typical arrangement of the above-described components. As in Example 8, in an actual implementation, the arrangement of the components and the connection of electrodes are properly determined so that a voltage controlled oscillator having a circuit configuration as shown in Figure **1** can be obtained.

The varactor diodes **4** and the passive chip components **5** such as capacitors and resistors may be incorporated in the Si substrate **11**.

The Si substrate **11** and the single crystalline piezoelectric substrate **2**' are bonded through direct bonding by attaching the surfaces of the two substrates to each other after the hydrophilic treatment of each surface and then heat-treating the attached substrates. By this direct bonding, the same functions and effects as those described in Example 8 are obtained. That is, with the above structure, since the oscillating circuit and the resonator can be integrally formed, the resultant voltage controlled oscillator can be made significantly smaller than the conventional ones. In practice, it is easy to reduce the volume of the oscillator to about a tenth and the weight thereof to about a fifth the conventional oscillator in which the surface acoustic wave resonator is first sealed in a container before being integrated. Other effects of the direct bonding described in Example 8 are also obtained.

Though the oscillator having the circuit configuration shown in Figure **1** is described in this example, it is needless to say that oscillators having other circuit configurations can also be integrated as described above.

The Si semiconductor substrate costs only a tenth or less the III-V group compound semiconductors. Further, since large-scale integration is possible with the Si substrate, it is possible to form a memory circuit on the Si semiconductor substrate for storing individual properties of the electro-acoustic element and correcting the stored properties.

### Example 22

A method for manufacturing the oscillator of Example 21 as a twenty second example of the present invention will be described.

The manufacturing process of this example is basically the same as that described in Example 10, except that the GaAs substrate **1** in Example 10 is replaced with the Si substrate **11,** and the quartz substrate **2** is replaced with the single crystalline piezoelectric substrate **2**' made of the material selected from the group consisting of lithium niobate, lithium tantalate, and lithium borate. The single crystalline piezoelectric substrate **2**' and the Si substrate **11** can also be bonded through direct bonding with each other by the hydrophilic treatment, the rinse with pure water, and the heat treatment after attaching the surfaces as described in Example 10. Necessary electronic circuits and wirings are also formed as described in Example 10. The temperature for the heat treatment can also be in the range of 100-800°C, so as to obtain favorable direct bonding. The electronic elements are formed on the Si substrate **11**.

Examples 23 to 35 relate to the invention for the states of NL and SE and to art related to the invention for the remaining states GB, DE and FR.

### Example 23

Figures **18A** and **18B** show the structure of a voltage controlled oscillator of Example 23 of the present invention for the states of NL and SE schematically, wherein the reference numeral **1** denotes a silicon (Si) substrate while the reference numeral **2** denotes a single crystalline piezoelectric substrate or a lithium niobate or lithium tantalate substrate which constitutes a surface acoustic wave resonator (SAW). The reference numeral **8** denotes a silicon compound thin film such as a silicon oxide film or a silicon film deposited on the silicon substrate **1** and/or on the single crystalline piezoelectric substrate **2**, and the film thickness is 0.1 µm to several µm. The silicon substrate **1** bonds through direct bonding with the single crystalline piezoelectric substrate **2** via the thin films **8**. A silicon film may also be used for direct bonding instead of the silicon oxide film **8**. The reference numeral **3** denotes a transistor formed on the silicon substrate **1** with photolithography process. Varactor diode chips (D) **4** with an electrostatic capacitance to vary with the applied voltage and passive chip components **5** such as capacitors, inductors and resistors are mounted on the silicon substrate **1**. Comb-like electrodes **6** are provided on the single crystalline piezoelectric substrate **2** to form the surface acoustic wave resonator, and wires **7**' connect the electors **6** with the metallic lines on the silicon substrate **1**. The components **2 - 5** mounted on the silicon substrate **1** and the two electrodes **6** are connected to form a voltage controlled oscillator. Further, the voltage controlled oscillator integrated on the silicon substrate **1** as a hybrid integrated circuit is sealed in a container (not shown).

The voltage controlled oscillator has for example a circuit shown in Figure **1**, and it comprises the transistor, the surface acoustic wave resonator (SAW) and the various electronics components **4**, **5** such as varactor diodes (D). This is a known circuit and detailed explanation is omitted here. The oscillation frequency of the output OUT of the voltage controlled oscillator can be changed according to the voltage V_{cont} applied to the varactor diodes **4**. Other circuits different from that shown in Figure **1** may also be used. The numbers of varactor diodes and other passive electronics components vary with a circuit, and the arrangement thereof on the semiconductor substrate is designed suitably for each case.

As explained above, in this voltage-controlled oscillator, the oscillator circuit and the surface acoustic wave resonator are integrated on a semiconductor substrate as a hybrid integrated circuit. Thus, the volume decreases easily to about a tenth the counterpart of a prior art structure with a surface acoustic wave resonator sealed in a container is used, while the weight also decreases to about a fifth the counterpart of the prior art structure.

The direct bonding has further advantages. In the present invention for the states of NL and SE, the silicon substrate and the single crystalline piezoelectric substrate **2** are bonded through direct bonding via the silicon oxide thin films **8** formed on one or both of the surfaces of the substrates **1** and **2**. That is, the bonding is performed via inorganic substances, and the semiconductor process can be performed further after the bonding. On the contrary, if the semiconductor substrate **1** and the single crystalline piezoelectric element **2** are bonded to each other with an ordinary bonding agent made from resin or the like, the semiconductor process cannot be further performed after the bonding owing to worse heat resistance and worse chemical resistance.

Further, if a bonding agent made from resin or the like is used, the degree of parallelization between the silicon substrate **1** and the lithium niobate or lithium tantalate substrate **2** becomes worse, and the precision of the size of the comb-type electrodes **6** formed with photolithography on the single crystalline piezoelectric substrate **2** thereafter becomes worse. For example, if the resonance frequency is of the order of 1 GHz, the electrode size is required to be about 1 µm of line and space width. Therefore, when the parallelization is worse, a surface acoustic wave resonator for the submicrowave band cannot be operated. On the contrary, in this example, the direct bonding is performed directly via the thin films **8**, and the film preparation can be controlled in general in the order of one nanometer. Thus, the above-mentioned problem can be solved. This effect of direct bonding is especially advantageous at high frequencies.

If a bonding agent made from resin is used, the secular change is another problem due to the thermal strain caused by the difference of thermal expansion coefficients between the resin as an organic material and the silicon substrate **1** and the single crystalline piezoelectric substrate **2** both made of inorganic materials. However, the present example solves this problem by direct bonding.

### Example 24

Figures **19A** and **19B** show the structure of a voltage controlled oscillator of Example 24 of the present invention for the states of NL and SE schematically of the same circuit as Example 23. The reference numerals **1 - 3** and **6 - 8** denote the same as in Example 23. That is, the reference numeral **1** denotes a silicon substrate, while the reference numeral **2** denotes a single crystalline piezoelectric substrate. The reference numeral **8** denotes a silicon compound film such as a silicon oxide film or a silicon film formed on the silicon substrate **1** and/or on the single crystalline piezoelectric substrate **2** for direct bonding of the silicon substrate **1** with the single crystalline piezoelectric substrate **2**. The reference numeral **3** denotes a field effect transistor **3**. The reference numeral **6** denotes an electrode of the surface acoustic wave resonator, and the reference numeral **7**' denotes a wire connecting the electrode **6** with the metallic lines on the silicon substrate **1**.

The reference numeral **4**' denotes a varactor diode chip, while the reference numeral **5**' denotes passive chip components such as capacitors. The components **3**, **4**', **5**' and the two electrodes **6** are connected to form a voltage controlled oscillator shown in Figure **3**. Further, the voltage controlled oscillator integrated as a hybrid integrated circuit is sealed in a container (not shown).

This example is different from Example 23 in a point that the varactor diode chips **4**' and the passive chip components **5**' are formed with photolithography process in the silicon substrate **1** as known in a semiconductor process. It is easy to integrate the varactor diode chips **4'** when the silicon substrate **1** is used. The resistors of the passive components **5**' can be made easily by forming silicon resistors made by diffusion process or thin film resistors made from tantalum nitride; the capacitors can be made easily by forming silicon nitride films; and the inductors can be made easily by forming spiral metal patterns. By adopting this structure, the voltage controlled oscillator can be made more compactly than that of Example 23. The mounting of the chip components **4** and **5** needed in Example 23 can be omitted in the manufacturing steps, and this is convenient for mass production.

### Example 25

An example of a manufacturing method of a voltage controlled oscillator is explained with reference to Figures **20** and **21.**

First, one or more depressed areas are formed in prescribed positions on a silicon substrate **1** with etching or the like and a series of semiconductor process, including a diffusion process, necessary for a field effect transistor **3**, varactor diodes **4** and the like is carried out at the heat treatment temperature for direct bonding or higher (step S1). The diffusion process is performed usually at a temperature as high as 1000°C or higher.

Next, a protection film is formed on the silicon section which has been subjected to the above-mentioned processes if necessary (step S2). The protection film is made of a metallic or oxide film which can resist the above-mentioned processes and can be removed finally. Then, the surface of a section used for the bonding later with a single crystalline piezoelectric substrate **2** is cleaned very much (step S3). In concrete, the surface layer of silicon is etched and removed with a fluoric acid etchant.

Then, a first silicon oxide film **8a** is formed on the silicon substrate 1 with a chemical vapor deposition process or the like (step S4). The film thickness of the silicon oxide and the uniformity of the films can be easily controlled for films of thickness of about 0.1-3 µm. The sputtering or the vacuum deposition may also be used.

The surface of the silicon oxide film **8a** is cleaned with the buffered fluoric acid, and the surface is subjected to a processing to make it hydrophilic (step S5).

On the other hand, the surface of the single crystalline piezoelectric substrate **2** is cleaned (step S11). Then, a second silicon oxide film **8b** is also formed on the single crystalline piezoelectric substrate **2** with a chemical vapor growth process or the like (step S12). The thickness and the uniformity of the second silicon oxide film **8b** can be controlled similarly to the first silicon oxide film.

The surface of the silicon oxide film **8b** is cleaned with the buffered fluoric acid, and the surface is subjected to a processing so as to make it hydrophilic (step S13).

Then, the surfaces of the first and second silicon oxide films **8a** and **8b** are cleaned sufficiently with pure water (steps S6 and S14). Next, the surfaces of the two silicon oxide films **8a** and **8b** are contacted uniformly immediately (step S21). Thus, the direct bonding between the silicon substrate **1** and the single crystalline piezoelectric substrate **2** can be formed through hydrogen bonds between hydroxyl groups absorbed on the surfaces of the silicon oxide films **8a** and **8b**. The as-formed direct bonding is sufficiently hard.

Furthermore, the bonding strength becomes harder by the heat treatment at 100-800°C, preferably at 300-600°C (step S22). When the heat treatment temperature is high, the shape, the size or the like of the single crystalline piezoelectric substrate **2** is limited somewhat due to the difference of the thermal expansion coefficients between the silicon substrate **1** and the single crystalline piezoelectric substrate **2**. However, the bonding strength can be improved essentially, without causing peel-off materials and damages, when the thickness and the area of the single crystalline piezoelectric substrate **2** are decreased with increase in the heat treatment temperature.

As to the effect of the heat treatment on the bonding strength, for example the heat treatment of on hour at 200°C can increase the bonding strength several times, to several tens kg/cm². If the temperature is increased above 800°C, lithium atoms leave for the surface of lithium niobate or lithium tantalate. Thus, the surface characteristic is deteriorated and the prescribed performance as a surface acoustic wave resonator cannot be obtained. Therefore, the bonding temperature has to be 800°C or lower when lithium niobate or lithium tantalate is used for the single crystalline piezoelectric substrate **2**.

Next, the protection film is removed if it is formed in step S2 (step S23). Then, various processes such as electrode formation which are processed at temperatures below the heat treatment temperature for bonding. Then, electrodes are formed on the surface of the single crystalline piezoelectric substrate with vacuum deposition or the like, and then the metal pattern is formed with a conventional photolithography (step S24). The electrodes are made from aluminum, gold/chromium or the like.

The direct bonding is possible even if a silicon oxide film **8** is formed only one of the substrates **1** and **2**, that is, only on the surface of the single crystalline piezoelectric substrate **2** or of the silicon substrate **1**. The bonding is also possible if the single crystalline piezoelectric substrate **2** is made from an oxide other than lithium niobate or lithium tantalate. The bonding temperature can be lowered by applying an electric voltage at the bonding interface.

The direct bonding is possible at room temperature and it can be carried out after all processes are completed.

If a controlled voltage oscillator of Example 24 is manufactured, the varactor diodes **4'** and the passive electronics components are fabricated in steps S1 and S24.

### Example 26

An example of a manufacturing method of a voltage controlled oscillator is explained with reference to Figures **20** and **21**. In this example, an amorphous silicon film is used for the film **8**.

Similarly to Example 25, one or more depressed areas are formed in prescribed positions on a silicon substrate **1** with etching or the like, and a series of semiconductor process, including a diffusion process, necessary for a field effect transistor **3**, varactor diodes **4** and the like is carried out at the heat treatment temperature for direct bonding or higher (step S1). Next, a protection film is formed on the silicon section which has been subjected to the abovementioned processes if necessary (step S2). Then, the surface of a section for direct bonding is cleaned very much (step S3). Then, a first amorphous silicon thin film **8a** is formed on the silicon substrate **1** with a plasma chemical vapor deposition process or the like (step S4). The film thickness of the amorphous silicon is about 0.1-3 µm as in Example 25. The surface of the amorphous silicon film **8a** is cleaned with the buffered fluoric acid, and the surface is subjected to a hydrophilic treatment to make it hydrophilic (step S5).

On the other hand, the surface of the single crystalline piezoelectric substrate **2** is cleaned (step S11). Then, a second amorphous silicon thin film **8b** of thickness of 0.1-0.3 µm is also formed on the single crystalline piezoelectric substrate **2** with a plasma chemical vapor deposition process or the like (step S12). The surface of the amorphous silicon film **8b** is cleaned with the buffered fluoric acid, and the surface is subjected to a processing to make it hydrophilic (step S13).

Then, the surfaces of the first and second amorphous silicon films **8a** and **8b** are cleaned sufficiently with pure water (step S14). Next, the surfaces of the two amorphous silicon films **8a** and **8b** are contacted uniformly immediately (step S21). Thus, the direct bonding between the silicon substrate **1** and the single crystalline piezoelectric substrate **2** can be formed through hydrogen bonds between hydroxyl groups on the surfaces of the amorphous silicon films **8a** and **8b**. The as-formed direct bonding is sufficiently strong.

Furthermore, the bonding becomes stronger by the heat treatment at 100-800°C, preferably at 300-600°C (step S22). Next, the protection film is removed if it is formed in step S2 (step S23). Then, various processes such as electrode formation which are processed at temperatures below the heat treatment temperature for direct bonding. Then, electrodes are formed on the surface of the single crystalline piezoelectric substrate with vacuum deposition or the like, and then the metal pattern is formed with a conventional photolithography (step S24). The electrodes are made from aluminum, gold/chromium or the like.

The bonding strength with use of amorphous silicon films is higher than that of Example 25 with use of silicon oxide films. Because the direct bonding is possible at room temperature, the bonding process (step S21) may be carried out after all processing is completed.

The direct bonding is possible even if an amorphous silicon film **8** is formed only one of the substrate **1**, **2**, that is only on the surface of the single crystalline piezoelectric substrate **2** or of the silicon substrate **1**. The direct bonding is also possible if the single crystalline piezoelectric substrate **2** is made from an oxide other than lithium niobate or lithium tantalate. electric voltage. The bonding temperature can he lowered by applying an electric voltage at the bonding interface.

### Example 27

Figure **22** shows an example of the structure of a voltage controlled oscillator of the present invention for the states of NL and SE. The perspective view of the voltage controlled oscillator is similar to Figure **18B** and it is not shown here. The reference numeral **11** denotes a GaAs substrate as a representative of III-V group compound semiconductors while the reference numeral **12** denotes a single crystalline piezoelectric substrate or a lithium niobate or lithium tantalate substrate which constitutes a surface acoustic wave resonator (SAW). The reference numeral **18** denotes a silicon compound film such as a silicon oxide film or a silicon film formed on the GaAs substrate **11** and/or on the single crystalline piezoelectric substrate **12**, and the film **18** bonds the GaAs substrate **11** directly with the single crystalline piezoelectric substrate **12** via the films **18**. A transistor **13** is formed on the GaAs substrate **11**. Varactor diode chips (D) **14** with an electrostatic capacitance to vary with the applied voltage and passive chip components **15** such as capacitors_{,} inductors and resistors are mounted on the GaAs substrate **11**. Comb-like electrodes **16** are provided on the single crystalline piezoelectric substrate **12** to form the surface acoustic wave resonator, and wires **17** connect the electrodes **16** with the metallic lines on the GaAs substrate **11**. The components **12 - 15** mounted on the GaAs substrate **11** and the two electrodes **16** are connected to form a voltage controlled oscillator as shown in Figure **1**. A voltage-controlled oscillator comprises the transistor, the various electronics components **14**, **15** and the surface acoustic wave resonator (SAW). Further, the voltage controlled oscillator integrated as a hybrid integrated circuit is sealed in a container (not shown).

Similarly to Example 23, by using this structure, the oscillator circuit and the surface acoustic wave resonator are integrated as a hybrid integrated circuit. Thus, the volume decreases easily to about a tenth the counterpart of a prior art structure wherein a surface acoustic wave resonator put in a closed container is used, while the weight also decreases to about a fifth the counterpart of the prior art structure. The above-mentioned problems with use of a bonding agent made from resin can also be avoided.

This example is different from Example 23 in the point that a GaAS substrate **11** is used instead of a silicon substrate **1**. III-V group compound semiconductors such as GaAs, InP and InGaAs have a larger mobility than silicon generally. The mobility of GaAs is about six times that of silicon. Therefore, a high speed semiconductor can be formed by using a III-V compound semiconductor, and a transistor which can be operated at several tens GHz can be formed easily. Thus, the operation at higher frequencies of an electro-acoustic hybrid integrated circuit becomes possible, and the voltage controlled oscillator of this example can be operated at higher frequencies than that of Example 23.

### Example 28

Figure **23** shows an example of the structure of a voltage controlled oscillator of the present invention for the states of NL and SE. The perspective view of the voltage controlled oscillator is similar to Figure **18B** and it is not shown here. The reference numerals **11 - 13** and **16 - 18** denote the same as in Example 27 (Figure 22). The silicon oxide or silicon film **18** bonds the GaAs substrate **11** and the single crystalline piezoelectric substrate **12** through direct bonding. The reference numeral **14**' denotes a varactor diode chip which changes the electrostatic capacitance with the applied voltage, and the reference numeral **15**' denotes passive chip components such as capacitors, inductors and resistors. The components on the GaAs substrate and the two electrodes of the surface acoustic wave resonator are connected to form a voltage controlled oscillator as shown in Figure **1**. The voltage controlled oscillator constructed integrated as explained above is put in a container (not shown).

This example is different from Example 27 in a point that the varactor diode chip **14**' and the passive chip components **15**' are made on the GaAs substrate **11** as a body integrally, similarly to Example 24. It is easy to integrate the varactors diode chips **14**' when the GaAs substrate **11** is used. The resistors can be made easily by forming GaAs resistors made by a diffusion process or thin film resistors made from tantalum nitride. The capacitors can be made easily by forming silicon nitride films, and the inductors can be made easily by forming a spiral metal pattern. By adopting this structure, the voltage controlled oscillator can be made more compactly than that of Example 25. The mounting of the chip components are not needed, and this makes mass production easy.

### Example 29

An example of a manufacturing method of voltage controlled oscillator of the present invention for the states of NL and SE is explained with reference to Figures **20** and **24**.

First, one or more depressed areas are formed in prescribed positions on a GaAs substrate **11** with etching or the like, and a series of semiconductor process, including a diffusion process, necessary for a field effect transistor **13**, varactor diodes **14** and the like is carried out at the heat treatment temperature for direct bonding or higher (step S1).

Next, a protection film is formed on the GaAs section which has been subject to the above-mentioned processes if necessary (step S2). The protection film is made of a metallic or oxide film which can resist the above-mentioned processes and can be finally removed. Then, the surface of a GaAs section used for the bonding later is cleaned thoroughly (step S3). Finally, the surface layer of GaAs is etched and removed with a fluoric acid etchant.

Then, a first silicon oxide thin film **18a** is formed on the GaAs substrate **11** with a chemical vapor deposition process or the like (step S4). The film thickness of the silicon oxide film can be controlled easily about 0.1-3 µm.

The surface of the silicon oxide film **18a** is cleaned with the buffered fluoric acid, and the surface is subjected to a hydrophilic treatment so as to make it hydrophilic (step S5).

On the other hand, the surface of the single crystalline piezoelectric substrate **12** is cleaned (step S11). Then, a second silicon oxide thin film **18b** is also formed on the single crystalline piezoelectric substrate **12** with a chemical vapor growth process or the like (step S12). The thickness and the uniformity of the second silicon oxide film **18b** can be controlled similarly to the first silicon oxide film.

The surface of the silicon oxide film **18** is cleaned with the buffered fluoric acid, and the surface is subjected to a processing to make it hydrophilic (Step S13).

Then, the surface of the first and second silicon oxide films **18a** and **18b** are cleaned sufficiently with pure water (steps S6 and S14). Next, the surface of the two silicon oxide films **18a** and **18b** are contacted uniformly immediately (step S21). Thus, the direct bonding between the GaAs substrate **11** and the single crystalline piezoelectric substrate **12** can be formed through hydrogen bonds between hydroxyl groups on the surfaces of the silicon oxide films **18a** and **18b**. The as-formed direct bonding is sufficiently hard.

Furthermore, the direct bonding becomes harder by the heat treatment at 100-800°c, preferably at 300-600°C (step S22). When the heat treatment temperature is high, the ranges of the shape, the size or the like of the single crystalline piezoelectric substrate **12** is limited somewhat due to the difference of the thermal expansion coefficients between the GaAs substrate **11** and the single crystalline piezoelectric substrate **12**. However, the bonding strength can be improved essentially, without causing peel-off materials and damages, when the thickness and the area of the single crystalline piezoelectric substrate **12** are decreased with increase in the heat treatment temperature.

The effect of the heat treatment on the bonding strength is similar to Example 25. If the temperature is increased above 800°C, lithium atoms leave from the surface of lithium niobate or lithium tantalate. Thus, the surface characteristic is deteriorated and the prescribed performance as a surface acoustic wave resonator cannot be obtained. Therefore, the direct bonding temperature has to be 800°C or lower when lithium niobate or lithium tantalate is used for the single crystalline piezoelectric substrate **2**.

Next, the protection film is removed if it is formed in step S2 (step S23). Then, various processes such as electrode formation which are processed at temperatures below the heat treatment temperature for bonding. Then, electrodes are formed on the surface of the single crystalline piezoelectric substrate with vacuum deposition or the like, and then the metal pattern is formed with a conventional photolithography (step S24). The electrodes are made from aluminum, gold/chromium or the like. Thus, the structure of Example 27 can be manufactured by using a method similar to Example 25.

The direct bonding is possible even if a silicon oxide film **18** is formed only one of the substrates **11**, **12**, that is, only on the surface of the single crystalline piezoelectric substrate **12** or of the GaAs substrate **11**. The direct bonding is also possible if the single crystalline piezoelectric substrate **12** is made from an oxide other than lithium niobate or lithium tantalate. Further, the direct bonding is also possible by using silicon oxide films when a III-V compound substrate other than GaAs substrate is used.

### Example 30

An example of a manufacturing method of a voltage controlled oscillator is explained with reference to Figures **20** and **24**. In this example, an amorphous silicon film is used for the film **18**.

Similarly to Example 29, one or more depressed areas are formed in prescribed positions on a GaAs substrate **11** with etching or the like, and a series of semiconductor process, including a diffusior process, necessary for a field effect transistor **13,** varactor diodes **14** and the like is carried out at the heat treatment temperature for direct bonding or higher (step S1). Next, a protection film is formed on the GaAs section which has been subjected to the above-mentioned processes if necessary (step S2). Then, the surface of a GaAs section used for bonding later is cleaned very much (step S3). In concrete, the surface layer of GaAs is etched and removed with a fluoric acid etchant.

Then, a first amorphous silicon thin film **18a** is formed on the GaAs substrate 11 with a plasma chemical vapor deposition process or the like (step S4). The film thickness of the amorphous film is about 0.1-3 µm as in Example 29. The surface of the amorphous silicon film **18a** is cleaned with the buffered fluoric acid, and the surface is subjected to a hydrophilic treatment make it hydrophilic (step S5).

On the other hand, the surface of the single crystalline piezoelectric substrate **12** is cleaned (step S11). Then, a second amorphous silicon thin film **18b** of a thickness of 0.1-0.3 µm is also formed on the single crystalline piezoelectric substrate **12** with a plasma chemical vapor deposition process or the like (step S12). The surface of the amorphous silicon film **18b** is cleaned with the buffered fluoric acid, and the surface is subjected to a processing to make it hydrophilic (step S13).

Then, the surfaces of the first and second amorphous oxide films are cleaned sufficiently with pure water (step S14). Next, the surfaces of the two amorphous silicon films **18a** and **18b** are contacted uniformly immediately (step S21). Thus, the direct bonding between the GaAs substrate 11 and the single crystalline piezoelectric substrate **12** can be formed through hydrogen bonds between hydroxyl groups on the surfaces of the amorphous silicon films **18a** and **18b.** The as-formed direct bonding is sufficiently hard.

Furthermore, steps S22 - S24 are performed to form an electro-acoustic hybrid integrated circuit wherein the GaAs substrate **11** and the electro-acoustic element are integrated.

The direct bonding is possible even if an amorphous silicon film **18** is formed if only one of the substrates **11** and **12,** that is, only on the surface of the single crystalline piezoelectric substrate **12** or of the GaAs substrate **11.** The direct bonding is also possible if the single crystalline piezoelectric substrate **12** is made from an oxide other than lithium niobate or lithium tantalate.

### Example 31

Figures **25A** and **25B** show an example of the structure of a voltage controlled oscillator of the present invention for the states of NL and SE, wherein the reference numeral **21** denotes a GaAs substrate, the reference numeral **22** denotes a quartz oscillator bonded to the GaAs substrate **21**, the reference numeral **23** denotes a transistor formed on the GaAs substrate **21**, the reference numeral **24** denotes a varactor diode chip which changes the electrostatic capacitance with the applied voltage, the reference numeral **25** denotes passive chip components such as capacitors, inductors and resistors, the reference numeral **26** denotes an upper electrode of the quartz oscillator **22** and the reference numeral **27** denotes a lower electrode arranged at the back side of the quartz oscillator **22**. A throughhole **21a** is provided in the GaAs substrate **21** just below the quartz oscillator **22** in order to connect the lower electrode **27** to the back side of the quartz oscillator **22**. The lower electrode **27** is connected electrically with the metal lines on the GaAs substrate **21** through a via-hole **29** (or a throughhole formed in the substrate **21,** covered with a conductor on the inside of the throughhole, to connect both sides of the substrate **21** electrically) or the like. Further, the components of the GaAs substrate **21** and the two electrodes of the quartz oscillator **22** are connected to form a voltage controlled oscillator as shown in Figure **25B**. The reference numeral **28** denotes a silicon oxide film or a silicon film formed on the GaAs substrate **21** and/or on the quartz oscillator **22** (except an area in correspondence to the throughhole **21a**) to bond the GaAs substrate **21** and the quartz oscillator **22** through direct bonding. Further, the voltage controlled oscillator is sealed in a closed container (not shown). The field effect transistor, the various electronics components and the quartz oscillator **22** constructs an oscillator shown in Figure **2**.

By adopting this structure, the volume decreases to about a tenth the counterpart of a prior art structure wherein a quartz oscillator put in a container is used, while the weight also decreases to about a fifth the counterpart of the prior art structure.

In this Example, the GaAs substrate **21** and the quartz (a single crystal of silicon oxide) **22** are bonded through direct bonding by using the silicon oxide at the surface of the quartz itself and the silicon oxide or silicon films formed on the GaAs substrate and/or on the quartz, without using an ordinary bonding agent made from resin or the like. Thus, advantages similar to Example 25 can be obtained.

Other voltage controlled oscillator circuits different from that shown in Figure **2** may also be used. The numbers of varactor diodes and other passive electronics components vary with each circuit, and the arrangement thereof on the semiconductor substrate is designed suitably for each case.

### Example 32

Figures **26A** and **26B** show an example of the structure of a voltage controlled oscillator of the present invention for the states of NL and SE, wherein the reference numerals **21** - **23** and **26 - 29** denote the same as in Example 31. The reference numeral **24'** denotes a varactor diode chip which changes the electrostatic capacitance with the applied voltage, and the reference numeral **25'** denotes passive chip components such as capacitors, inductors and resistors. The lower electrode **27** is connected with the metal lines on the GaAs substrate **21** through a via-hole **29**. Further, the components of the GaAs substrate **21** and the two electrodes of the quartz oscillator **22** are connected to form a voltage controlled oscillator. The voltage controlled oscillator constructed as explained above is sealed in a closed container (not shown).

This example is different from Example 31 in a point that the varactor diode chip **24**' and the passive chip components **25**' are integrated directly in the GaAs substrate **21** as in Example 28. By adopting this structure, the voltage controlled oscillator can be made more compactly than that of Example 31. The mounting of the chip components **24**' and **25**' are not needed, similarly to Example 28, and this makes mass production easy.

### Example 33

An example of a manufacturing method of voltage controlled oscillator of the present invention for the states of NL and SE is explained with reference to Figures **27** and **29**.

First, one or more depressed areas are formed in prescribed positions on a GaAs substrate **21** as an example of III-V compound semiconductor with etching or the like, and a series of semiconductor process, including a diffusion process, necessary for a field effect transistor **23**, varactor diodes **24** and the like is carried out at the heat treatment temperature for direct bonding or higher (step S41). The diffusion process is performed usually at a temperature as high as 870°C or higher.

Next, a protection film is formed on the GaAs section which has been subjected to the above-mentioned processes if necessary (step S42). The protection film is made of a metallic or oxide film which can resist the above-mentioned processes and can be removed finally. Then, the surface of a section for the direct bonding is cleaned very much (step S43). In concrete, the surface layer of GaAs is etched and removed with a fluoric acid etchant.

Then, a first silicon oxide thin film **28a** is formed on an area on the GaAs substrate **21** with a chemical vapor growth process or the like (step S44). The film thickness of the silicon oxide and the uniformity of the films can be controlled easily for films of thickness of about 0.1-3 µm.

The surface of the silicon oxide film **28a** is cleaned with the buffered fluoric acid, and the surface is subjected to a hydrophilic treatment to make it hydrophilic (step S45).

On the other hand, the surface of the quartz oscillator **22** is cleaned (step S51). Then, a second silicon oxide thin film **28b** is also formed on the quartz oscillator **2** with a chemical vapor growth process or the like (step S52). The thickness and the uniformity of the second silicon oxide film **28b** can be controlled similarly to the first silicon oxide film.

The surface of the silicon oxide film **28b** is cleaned with the buffered fluoric acid, and the surface is subjected to a processing to make it hydrophilic (step S53).

Then, the surface of the first and second silicon oxide films **28a** and **28b** are cleaned sufficiently with pure water (steps S46 and S54). Next, the surfaces of the two silicon oxide films **28a** and **28b** are contacted uniformly immediately (step S61). Thus, the direct bonding between the silicon substrate **21** and the quartz oscillator **22** can be formed through hydrogen bonds between s hydroxyl groups on the surfaces of the silicon oxide films **28a** and **28b.** The as-formed direct bonding is sufficiently hard.

Furthermore, the bonding becomes harder by the heat treatment at 100-860°C, preferably at 300-600°C (step S62). When the heat treatment temperature is high, the ranges of the shape, the size or the like of the quartz oscillator **22** is limited somewhat due to the difference of the thermal expansion coefficients between the silicon substrate **21** and the quartz oscillator **22.** However, the bonding strength can be improved essentially, without causing peel-off materials and damages, when the thickness and the area of the quartz oscillator **22** are decreased with increase in the heat treatment temperature.

As to the effect of the heat treatment on the bonding strength, for example the heat treatment of one hour at 200°C can increase the bonding strength several times, to several tens kg/cm². If the temperature is increased above 870°C, the crystal structure of quartz changes. Therefore, the bonding temperature has to be 860°C or lower.

Then, if necessary, the quartz substrate is thinned as explained in Example 34 (step S63).

Next, a hole **21a** is formed just below the quartz oscillator **22**, and the silicon oxide film **28** exposed through the hole **21a** etch away after the remaining part is covered with a resist or the like. Then, the resist and the protection film, if the protection film is formed in step S42, are removed (step S64). Then, various processes such as electrode formation which are processed at temperatures below the heat treatment temperature for bonding and below 860°C. Then, electrodes **23** and **24** are formed on the two surfaces of the quartz oscillator **22** with vacuum deposition or the like, and then the metal pattern is formed with a conventional photolithography (step S65). The electrodes are made from aluminum, gold/chromium or the like.

### Example 34

An example of a manufacturing method of voltage controlled oscillator is explained with reference to Figures **27** and **28**.

Similar to Example 33, after at least an active element is formed on a prescribed recess, the bonding with a quartz plate **22** is performed (steps S61 and S62). Next, the quartz oscillator **22** is processed to decrease the thickness with polishing or etching (step S63). Thus, for example, a quartz substrate of initial thickness of 200 µm can be formed easily to have the thickness of 5 µm or less. If a precise etching process is used, the quartz plate can be made thin further to thickness of 1 µm. If quartz AT cut is used, the thickness of 1 µm makes it possible to oscillate at about 1.6 GHz of fundamental wave. Then, by performing processes (steps S64 and S65) similar to those of Example 33, a voltage controlled oscillator which integrates the GaAs substrate **21** and the quartz oscillator **22** can be produced.

Such a voltage controlled oscillator can oscillate at a frequency as high as 1.6 GHz which cannot be realized previously. Especially, if a GaAs substrate **22** is used, a transistor which operates at frequencies higher by several times than a silicon transistor, the thin quartz oscillator is very advantageous at a high frequency region of 1 GHz or higher.

Further, if the frequency exceeds 1 GHz, the long metallic lines deteriorates the high frequency characteristic. However, the integration according to this Example can improves the performance.

### Example 35

An example of a manufacturing method of voltage controlled oscillator is explained with reference to Figures **27** and **29**. In this example, an amorphous silicon thin film is used for direct bonding.

Similarly to Example 33, after at least an active element is formed on a prescribed recess, an amorphous silicon film is formed with plasma CVD or the like at least on the GaAs substrate as a bonding plane (step S44). The film thickness of the amorphous silicon is about 0.1-3 µm, similarly to Example 33. Then, the surfaces of the amorphous silicon film **28a** and of the quartz oscillator **22** are made very clean (steps S45 and S53). The cleaning process is roughly similar to Example 33. The silicon surface is cleaned with an etchant of buffered fluoric acid. Then, the two surfaces are cleaned with pure water sufficiently and they are layered uniformly immediately (steps S46, S54 and S61). Thus, the direct bonding can be realized easily. Then, the bonding is enhanced by heat treatment. Next, the quartz plate can be thinned further if necessary with polishing or etching similarly to in Example 34. Then, by performing processes similar to those of Example 33 (steps S62 - 65), a voltage controlled oscillator which integrates the GaAs substrate and the quartz oscillator can be produced, and advantages similar to Examples 33 and 34 can be obtained. The direct bonding is possible at room temperature, and it can be carried out after all processes are completed.

The direct bonding is possible even if an amorphous silicon oxide film is formed only one of the substrates **21** and **22**, that is, only on the surface of the quartz plate **22** or of the silicon substrate **21**. A lithium niobate or lithium tantalate may also be used instead of the quartz oscillator.

As a silicon compound for the direct bonding, a silicon oxide is used in the examples mentioned above. Silicon oxide films prepared by a chemical vapor deposition process varies somewhat with the conditions of the deposition. Nitrogen atoms may also be included in a silicon oxide film. However, the direct bonding is possible in these cases.

In Examples 23 and 24, the lower electrode of the quartz crystal resonator is electrically connected onto the surface of the semiconductor substrate through the via-hole perforatedly provided therethrough. However, it may be structured so that the lower surface of the semiconductor substrate becomes a common ground electrode. In this case, the via-hole does not need to be provided.

In each example, the voltage controlled oscillator was exemplified as the preferred example, however, when a temperature compensated quartz crystal oscillator is to be taken as an example, it can be produced in the same way as already explained above and obtains the same effects as those shown above even if a temperature detection circuit and a control circuit for feeding the detected temperature back to a oscillating circuit are additionally provided to a circuit of each example as a chip component part. In addition, using the quartz crystal resonator as a resonance type frequency filter and structuring an amplification apparatus of a high-frequency receiving circuit can be obtained, which also can be obtained the same effects as those shown in the above-described examples. In other words, such effects as to be small in size and weight, high in performance and low in cost can be obtained.

Though the above-mentioned examples relate to voltage controlled oscillators, it is apparent that the present invention can be applied not only to a voltage controlled oscillator but also to other electro-acoustic circuits such as a high frequency amplifier (Figure **3**) and a temperature compensated crystal oscillator (Figure **4**) by bonding an electro-acoustic element (F, X) directly to a semiconductor substrate for a transistor element.

The hybrid integrate circuits and the manufacturing methods of the examples have the advantages explained below.

Because fundamental elements of a transistor and an electro-acoustic element such as a surface acoustic wave resonator for generating oscillation are integrated as one body, the size and the weight of an electro-acoustic circuit can be reduced to a large extent.

Because a semiconductor substrate and an electro-acoustic element are bonded through direct bonding, the planar property is very good, and the submicron photolithography necessary for the setting of oscillation frequency can be used. Further, the reliability on heat and vibration can be improved to a large extent.

If polishing or etching processing of quartz is performed, the thickness can be decreased to 5 µm or less easily. Therefore, a voltage controlled oscillator of a fundamental wave in the submicrowave band (several hundreds MHz to several GHz) can be manufactured easily. Then, the voltage controlled oscillator will have better performance at a lower cost.

When the integration is performed on a GaAs substrate, the high frequency characteristic of a transistor made on a substrate can be improved several time than a case with use of a silicon transistor. Then, the performance as a voltage controlled oscillator can be extended to higher frequencies.

The direct bonding at room temperature is essentially possible, and the degree of freedom of the manufacturing processes is vary large. This is favorable for the mass production.

Although the present invention has been fully described in connection with the preferred examples thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims (Claims for the following Contracting State(s): DE, GB, FR)

1. An electro-acoustic integrated circuit comprising:
a III-V group compound semiconductor substrate (1);
at least one active element (3, 3') formed on the surface of said semiconductor substrate (1); and
a piezoelectric plate (2) being bonded with said semiconductor substrate (1) by directly attaching a surface of said piezoelectric plate (2) and a surface of said semiconductor substrate (1);
wherein at least one electro-acoustic element comprising said piezoelectric plate (2) is connected to said active element (3, 3') to form an electro-acoustic integrated circuit, characterised in that said bonding is direct bonding.

2. An electro-acoustic integrated circuit comprising:
a silicon semiconductor substrate (1);
at least one active element (3, 3') formed on the surface of said semiconductor substrate (1); and
a piezoelectric plate (2) consisting of a member selected from lithium niobate, lithium tantalate, and lithium borate being bonded with said semiconductor substrate (1) by directly attaching a surface of said piezoelectric plate (2) and a surface of said semiconductor substrate (1);
wherein at least one electro-acoustic element comprising said piezoelectric plate (2) is connected to said active element (3, 3') to form an electro-acoustic integrated circuit, characterised in that said bonding is direct bonding.

3. An electro-acoustic integrated circuit according to claim 1 or 2, wherein the piezoelectric plate (2) is a single crystalline piezoelectric substrate.

4. A high frequency amplifier comprising:
a III-V group compound semiconductor substrate (1);
at least one active element (3, 3') formed on the surface of said semiconductor substrate (1); and
a piezoelectric plate (2) being bonded with said semiconductor substrate (1) by directly attaching a surface of said piezoelectric plate (2) and a surface of said semiconductor substrate (1);
wherein at least one electro-acoustic element comprising said piezoelectric plate (2) is connected to said active element (3) to form an electro-acoustic integrated circuit, characterised in that said bonding is direct bonding.

5. A high frequency amplifier comprising:
a silicon semiconductor substrate (1);
at least one active element (3, 3') formed on the surface of said semiconductor substrate (1); and
a piezoelectric plate (2) consisting of a member selected from lithium niobate, lithium tantalate, and lithium borate being bonded with said semiconductor substrate (1) by directly attaching a surface of said piezoelectric plate (2) and a surface of said semiconductor substrate (1);
wherein at least one electro-acoustic element comprising said piezoelectric plate (2') is connected to said active element (3, 3') to form an electro-acoustic integrated circuit, characterised in that said bonding is direct bonding.

6. An electro-acoustic integrated circuit according to claim 1 or 4, wherein said III-V group compound semiconductor substrate (1) is GaAs.

7. An electro-acoustic integrated circuit according to claim 1 or 4, wherein said III-V group compound semiconductor substrate (1) is InP.

8. A high frequency amplifier according to claim 4 or 5, wherein said piezoelectric plate (2') is lithium niobate.

9. A high frequency amplifier according to claim 4 or 5, wherein said piezoelectric plate (2') is lithium tantalate.

10. A high frequency amplifier according to claim 4 or 5, wherein said piezoelectric plate (2') is lithium borate.

11. A high frequency amplifier according to claim 4, wherein said piezoelectric plate (2') is quartz crystal.

12. An electro-acoustic integrated circuit according to claim 1 or 2, wherein said electro-acoustic element is a surface acoustic wave device.

13. An electro-acoustic integrated circuit according to one of claims 1 to 5, wherein said active element includes a transistor (3).

14. An electro-acoustic integrated circuit according to claim 1 or 2, wherein said electro-acoustic integrated circuit is an oscillator.

15. An electro-acoustic integrated circuit according to claim 1 or 2, wherein said electro-acoustic integrated circuit is a high frequency amplifier.

16. An electro-acoustic integrated circuit according to claim 1 or 2, wherein said electro-acoustic element is a bulk acoustic wave device.

17. A manufacturing method of an electro-acoustic hybrid integrated circuit comprising the steps of:
providing a III-V group compound semiconductor substrate (1) having opposite first and second surfaces;
providing a piezoelectric plate (2) having opposite first and second surfaces; characterised by
treating said first surface of said III-V group compound semiconductor substrate (1') and
said second surface of said piezoelectric plate (2) to make them hydrophilic;
attaching said semiconductor substrate (1') directly to said single piezoelectric plate (2) with said treated surfaces to form direct bonding.

18. A manufacturing method of an electro-acoustic hybrid integrated circuit comprising the steps of:
providing a silicon semiconductor substrate (1) having opposite first and second surfaces; providing a piezoelectric plate (2), having opposite first and second surfaces; characterised by
treating said first surface of said silicon semiconductor substrate (1) and said second surface of said piezoelectric plate (2) to make them hydrophilic;
attaching said semiconductor substrate (1) directly to said piezoelectric plate (2) with said treated surfaces to form direct bonding.

19. A manufacturing method of a high frequency amplifier comprising the steps of:
providing a III-V group compound semiconductor substrate (1') having opposite first and second surfaces;
providing a piezoelectric plate (2) having opposite first and second surfaces; characterised by
treating said first surface of said III-V group compound semiconductor substrate (1') and said second surface of said piezoelectric plate (2) to make them hydrophilic;
attaching said semiconductor substrate (1') directly to said piezoelectric plate (2) with said treated surfaces to form direct bonding.

20. A manufacturing method of a high frequency amplifier comprising the steps of:
providing a silicon semiconductor substrate (1) having opposite first and second surfaces;
providing a piezoelectric plate (2'), having opposite first and second surfaces, consisting a of member selected from lithium niobate, lithium tantalate, and lithium borate; characterised by
treating said first surface of said silicon semiconductor substrate (1) and said second surface of said piezoelectric plate (2') to make them hydrophilic;
attaching said semiconductor substrate (1) directly to said piezoelectric plate (2') with said treated surfaces to form direct bonding.

21. A manufacturing method of a high frequency amplifier according to claim 19 or 20, wherein as piezoelectric plate (2, 2') a single crystalline piezoelectric substrate is provided.

22. A manufacturing method according to claim 21, further comprising the step of: heating said bonded semiconductor substrate (1, 1') and said piezoelectric plate (2, 2').

23. A manufacturing method according to one of claims 21 or 22, wherein said hydrophilic treatment comprises a step using a solution of ammonia-hydrogen peroxide.

24. A manufacturing method according to claim 22, wherein said heat treatment is performed at a temperature from 100°C to 500°C.

## Claims (Claims for the following Contracting State(s): NL, SE)

1. An electro-acoustic integrated circuit comprising:
a III-V group compound semiconductor substrate (1');
at least one active element (3, 3') formed on the surface of said semiconductor substrate (1'); and
a piezoelectric plate (2) being bonded to said semiconductor substrate (1);
wherein at least one electro-acoustic element comprising said piezoelectric plate (2) is connected to said active element (3) to form an electro-acoustic integrated circuit;
characterized in that:
the piezoelectric plate (2) is bonded through direct bonding to the semiconductor substrate (1').

2. An electro-acoustic integrated circuit comprising:
a silicon semiconductor substrate (1);
at least one active element (3, 3') formed on the surface of said semiconductor substrate (1); and
a piezoelectric plate (2') consisting of a member selected from lithium niobate, lithium tantalate, and lithium borate being bonded to said semiconductor substrate;
wherein at least one electro-acoustic element comprising said piezoelectric plate (2') is connected to said active element (3, 3') to form an electro-acoustic integrated circuit;
characterized in that:
the piezoelectric plate (2') is bonded through direct bonding to the semiconductor substrate (1).

3. An electro-acoustic integrated circuit according to claim 1, wherein said piezoelectric plate (2') is a single crystalline piezoelectric substrate.

4. An electro-acoustic integrated circuit according to claim 2, wherein said piezoelectric plate (2) is a single crystalline piezoelectric substrate.

5. An electro-acoustic integrated circuit according to claim 3, wherein said III-V group compound semiconductor substrate (1') is GaAs.

6. An electro-acoustic integrated circuit according to claim 3, wherein said III-V group compound semiconductor substrate (1') is InP.

7. An electro-acoustic integrated circuit according to claim 3 or 4, wherein said piezoelectric plate (2') is lithium niobate.

8. An electro-acoustic integrated circuit according to claim 3 or 4, wherein said piezoelectric plate (2') is lithium tantalate.

9. An electro-acoustic integrated circuit according to claim 3 or 4, wherein said piezoelectric plate (2') is lithium borate.

10. An electro-acoustic integrated circuit according to claim 3, wherein said piezoelectric plate (2') is quartz crystal.

11. An electro-acoustic integrated circuit according to claim 3 or 4, wherein said electro-acoustic element is a surface acoustic wave device.

12. An electro-acoustic integrated circuit according to claim 3 or 4, wherein said active element includes a transistor (3).

13. An electro-acoustic integrated circuit according to claim 3 or 4, wherein said electro-acoustic integrated circuit is an oscillator.

14. An electro-acoustic integrated circuit according to claim 3 or 4, wherein said electro-acoustic integrated circuit is a high frequency amplifier.

15. An electro-acoustic integrated circuit according to claim 3 or 4, wherein said electro-acoustic element is a bulk acoustic wave device.

16. A manufacturing method of an electro-acoustic hybrid integrated circuit comprising the steps of:
providing a III-V group compound semiconductor substrate (1') having opposite first and second surfaces;
providing a piezoelectric plate (2) having opposite first and second surfaces;
treating said first surface of said III-V group compound semiconductor substrate (1') and said second surface of said piezoelectric plate (2) to make them hydrophilic;
attaching said semiconductor substrate (1') directly to said piezoelectric plate (2) with said treated surfaces to form direct bonding.

17. A manufacturing method of an electro-acoustic hybrid integrated circuit comprising the steps of:
providing a silicon semiconductor substrate (1) having opposite first and second surfaces;
providing a piezoelectric plate (2'), having opposite first and second surfaces, consisting of a member selected from lithium niobate, lithium tantalate, and lithium borate;
treating said first surface of said silicon semiconductor substrate (1) and said second surface of said piezoelectric plate (2') to make them hydrophilic;
attaching said semiconductor substrate (1) directly to said piezoelectric plate (2') with said treated surfaces to form direct bonding.

18. A manufacturing method of an electro-acoustic hybrid integrated circuit according to claim 16 or 17, wherein as piezoelectric plate (2, 2') a single crystalline piezoelectric substrate is provided.

19. A manufacturing method of an electro-acoustic hybrid integrated circuit according to claim 18, further comprising the step of:
heating said bonded semiconductor substrate (1, 1') and said piezoelectric plate (2, 2').

20. A manufacturing method of an electro-acoustic hybrid integrated circuit according to claim 18 or 19, wherein said hydrophilic treatment comprises a step using a solution of ammonia-hydrogen peroxide.

21. A manufacturing method of an electro-acoustic hybrid integrated circuit according to claim 19, wherein said heat treatment is performed at a temperature from 100°C to 500°C.

## Patentansprüche (Patentansprüche für folgende(n) Vertragsstaat(en): DE, GB, FR)

1. Elektroakustische integrierte Schaltung, umfassend:
ein Substrat (1) eines Verbindungshalbleiters der III-V-Gruppe;
mindestens ein aktives Element (3, 3'), das auf der Oberfläche des Halbleitersubstrats (1) gebildet ist; und
eine piezoelektrische Platte (2), die an das Halbleitersubstrat (1) durch direktes Befestigen einer Oberfläche der piezoelektrischen Platte (2) und einer Oberfläche des Halbleitersubstrats (1) gebondet ist;
wobei mindestens ein elektroakustisches Element, das die piezoelektrische Platte (2) umfaßt, mit dem aktiven Element (3, 3') verbunden ist, um eine elektroakustische integrierte Schaltung zu bilden,
dadurch gekennzeichnet, daß
das Bonden ein direktes Bonden ist.

2. Elektroakustische integrierte Schaltung, umfassend:
ein Siliciumhalbleitersubstrat (1);
mindestens ein aktives Element (3, 3'), das auf der Oberfläche des Halbleitersubstrats (1) gebildet ist; und
eine piezoelektrische Platte (2), die aus einem Teil, das aus Lithiumniobat, Lithiumtantalat und Lithiumborat ausgewählt ist, besteht und an das Halbleitersubstrat (1) durch direktes Befestigen einer Oberfläche der piezoelektrischen Platte (2) und einer Oberfläche des Halbleitersubstrats (1) gebondet ist;
wobei mindestens ein elektroakustisches Element, das die piezoelektrische Platte (2) umfaßt, mit dem aktiven Element (3, 3') verbunden ist, um eine elektroakustische integrierte Schaltung zu bilden,
dadurch gekennzeichnet, daß
das Bonden ein direktes Bonden ist.

3. Elektroakustische integrierte Schaltung nach Anspruch 1 oder 2, wobei die piezoelektrische Platte (2) ein einkristallines piezoelektrisches Substrat ist.

4. Hochfrequenzverstärker, umfassend:
ein Substrat (1) eines Verbindungshalbleiters der III-V-Gruppe;
mindestens ein aktives Element (3, 3'), das auf der Oberfläche des Halbleitersubstrats (1) gebildet ist; und
eine piezoelektrische Platte (2), die an das Halbleitersubstrat (1) durch direktes Befestigen einer Oberfläche der piezoelektrischen Platte (2) und einer Oberfläche des Halbleitersubstrats (1) gebondet ist,
wobei mindestens ein elektroakustisches Element, das die piezoelektrische Platte (2) aufweist, mit dem aktiven Element (3) verbunden ist, um eine elektroakustische integrierte Schaltung zu bilden,
dadurch gekennzeichnet, daß
das Bonden ein direktes Bonden ist.

5. Hochfrequenzverstärker, umfassend:
ein Siliciumhalbleitersubstrat (1);
mindestens ein aktives Element (3, 3'), das auf der Oberfläche des Halbleitersubstrats (1) gebildet ist; und
eine piezoelektrische Platte (2), die aus einem Teil, das aus Lithiumniobat, Lithiumtantalat und Lithiumborat ausgewählt ist, besteht und das an das Halbleitersubstrat (1) durch direktes Befestigen einer Oberfläche der piezoelektrischen Platte (2) und einer Oberfläche des Halbleitersubstrats (1) gebondet ist,
wobei mindestens ein elektroakustisches Element, das die piezoelektrische Platte (2') umfaßt, mit dem aktiven Element (3, 3') verbunden ist, um eine elektroakustische integrierte Schaltung zu bilden,
dadurch gekennzeichnet, daß
das Bonden ein direktes Bonden ist.

6. Elektroakustische integrierte Schaltung nach Anspruch 1 oder 4, wobei das Substrat (1) eines Verbindungshalbleiters der III-V-Gruppe aus GaAs ist.

7. Elektroakustische integrierte Schaltung nach Anspruch 1 oder 4, wobei das Substrat (1) eines Verbindungshalbleiters der III-V-Gruppe aus InP ist.

8. Hochfrequenzverstärker nach Anspruch 4 oder 5, wobei die piezoelektrische Platte (2') aus Lithiumniobat ist.

9. Hochfrequenzverstärker nach Anspruch 4 oder 5, wobei die piezoelektrische Platte (2') aus Lithiumtantalat ist.

10. Hochfrequenzverstärker nach Anspruch 4 oder 5, wobei die piezoelektrische Platte (2') aus Lithiumborat ist.

11. Hochfrequenzverstärker nach Anspruch 4, wobei die piezoelektrische Platte (2') ein Quarzkristall ist.

12. Elektroakustische integrierte Schaltung nach Anspruch 1 oder 2, wobei das elektroakustische Element ein Oberflächenschallwellen-Bauteil ist.

13. Elektroakustische integrierte Schaltung nach einem der Ansprüche 1 bis 5, wobei das aktive Element einen Transistor (3) einschließt.

14. Elektroakustische integrierte Schaltung nach Anspruch 1 oder 2, wobei die elektroakustische integrierte Schaltung ein Oszillator ist.

15. Elektroakustische integrierte Schaltung nach Anspruch 1 oder 2, wobei die elektroakustische integrierte Schaltung ein Hochfrequenzverstärker ist.

16. Elektroakustische integrierte Schaltung nach Anspruch 1 oder 2, wobei das elektroakustische Element ein Körperschallwellen- Bauteil ist.

17. Herstellungsverfahren einer elektroakustischen integrierten Hybridschaltung, umfassend die Schritte:
Bereitstellen eines Substrats (1) eines Verbindungshalbleiters der III-V-Gruppe, das gegenüberliegende erste und zweite Flächen aufweist;
Bereitstellen einer piezoelektrischen Platte (2), die gegenüberliegende erste und zweite Oberflächen aufweist;
gekennzeichnet durch
Behandeln der ersten Oberfläche des Substrats (1') eines Verbindunghalbleiters der III-V-Gruppe, und
der zweiten Oberfläche der piezoelektrischen Platte (2), um sie hydrophil zu machen;
Befestigen des Halbleitersubstrats (1') direkt an der einzelnen piezoelektrischen Platte (2) mit den behandelten Oberflächen, um ein direktes Bonden zu bilden.

18. Herstellungsverfahren einer elektroakustischen integrierten Hybridschaltung, umfassend die Schritte:
Bereitstellen eines Siliciumhalbleitersubstrats (1), das gegenüberliegende erste und zweite Oberflächen aufweist;
Bereitstellen einer piezoelektrischen Platte (2), die gegenüberliegende erste und zweite Oberflächen aufweist,
gekennzeichnet durch:
Behandeln der ersten Oberfläche des Substrats (1) eines Verbindungshalbleiters der III-V-Gruppe und der zweiten Oberfläche der piezoelektrischen Platte (2), um sie hydrophil zu machen;
Befestigen des Halbleitersubstrats (1') direkt an der piezoelektrischen Platte (2) mit den behandelten Oberflächen, um ein direktes Bonden zu bilden.

19. Herstellungsverfahren eines Hochfrequenzverstärkers, umfassend die Schritte:
Bereitstellen eines Substrats (1') eines Verbindunghalbleiters der III-V-Gruppe, das gegenüberliegende erste und zweite Oberflächen aufweist;
Bereitstellen einer piezoelektrischen Platte (2), die gegenüberliegende erste und zweite Oberflächen aufweist;
gekennzeichnet durch
Behandeln der ersten Oberfläche des Substrats (1') eines Verbindungshalbleiters der III-V-Gruppe und der zweiten Oberfläche der piezoelektrischen Platte (2), um sie hydrophil zu machen;
Befestigen des Halbleitersubstrats (1') direkt an der piezoelektrischen Platte (2) mit der behandelten Oberfläche, um ein direktes Bonden zu bilden.

20. Herstellungsverfahren eines Hochfrequenzverstärkers, das die Schritte umfaßt:
Bereitstellen eines Siliciumhalbleitersubstrats (1), das gegenüberliegende erste und zweite Oberflächen aufweist;
Bereitstellen einer piezoelektrischen Platte (2'), die gegenüberliegende erste und zweite Oberflächen aufweist, die aus einem Teil, das aus Lithiumniobat, Lithiumtantalat und Lithiumborat ausgewählt ist, besteht;
gekennzeichnet durch
Behandeln der ersten Oberfläche des Siliciumhalbleitersubstrats (1) und der zweiten Oberfläche der piezoelektrischen Platte (2'), um sie hydrophil zu machen;
Befestigen des Halbleitersubstrats (1) direkt an der piezoelektrischen Platte (2') mit den behandelten Oberflächen, um ein direktes Bonden zu bilden.

21. Herstellungsverfahren eines Hochfrequenzverstärkers nach Anspruch 19 oder 20, wobei als piezoelektrische Platte (2, 2') ein einkristallines piezoelektrisches Substrat bereitgestellt wird.

22. Herstellungsverfahren nach Anspruch 21, das weiterhin den Schritt umfaßt: Heizen des gebondeten Halbleitersubstrats (1, 1') und der piezoelektrischen Platte (2, 2').

23. Herstellungsverfahren nach einem der Ansprüche 21 oder 22, wobei die hydrophile Behandlung einen Schritt des Verwendens einer Lösung aus Ammoniumhydrogenperoxid umfaßt.

24. Herstellungsverfahren nach Anspruch 22, wobei die Wärmebehandlung bei einer Temperatur von 100 °C bis 500 °C durchgeführt wird.

## Patentansprüche (Patentansprüche für folgende(n) Vertragsstaat(en): NL, SE)

1. Elektroakustische integrierte Schaltung, umfassend:
ein Substrat (1') eines Verbindungshalbleiters der III-V-Gruppe;
mindestens ein aktives Element (3, 3'), das auf der Oberfläche des Halbleitersubstrats (1') gebildet ist; und
eine piezoelektrische Platte (2), die an das Halbleitersubstrat (1) gebondet ist;
wobei mindestens ein elektroakustisches Element, das die piezoelektrische Platte (2) umfaßt, mit dem aktiven Element (3) verbunden ist, um eine elektroakustische integrierte Schaltung zu bilden,
dadurch gekennzeichnet, daß
die piezoelektrischen Platte (2) durch direktes Bonden an das Halbleitersubstrats (1) gebondet ist.

2. Elektroakustische integrierte Schaltung, umfassend:
ein Siliciumhalbleitersubstrat (1);
mindestens ein aktives Element (3, 3'), das auf der Oberfläche des Halbleitersubstrats (1) gebildet ist; und
eine piezoelektrische Platte (2'), die aus einem Teil, das aus Lithiumniobat, Lithiumtantalat und Lithiumborat ausgewählt ist, besteht und an das Halbleitersubstrat gebondet ist;
wobei mindestens ein elektroakustisches Element, das die piezoelektrische Platte (2') umfaßt, mit dem aktiven Element (3, 3') verbunden ist, um eine elektroakustische integrierte Schaltung zu bilden,
dadurch gekennzeichnet, daß
die piezoelektrischen Platte (2') durch direktes Bonden an das Halbleitersubstrats (1) gebondet ist.

3. Elektroakustische integrierte Schaltung nach Anspruch 1, wobei die piezoelektrische Platte (2') ein einkristallines piezoelektrisches Substrat ist.

4. Elektroakustische integrierte Schaltung nach Anspruch 2, wobei die piezoelektrische Platte (2) ein einkristallines piezoelektrisches Substrat ist.

5. Elektroakustische integrierte Schaltung nach Anspruch 3, wobei das Substrat (1') eines Verbindungshalbleiters der III-V-Gruppe aus GaAs ist.

6. Elektroakustische integrierte Schaltung nach Anspruch 3, wobei das Substrat (1') eines Verbindungshalbleiters der III-V-Gruppe aus InP ist.

7. Elektroakustische integrierte Schaltung nach Anspruch 3 oder 4, wobei die piezoelektrische Platte (2') aus Lithiumniobat ist.

8. Elektroakustische integrierte Schaltung nach Anspruch 3 oder 4, wobei die piezoelektrische Platte (2') aus Lithiumtantalat ist.

9. Elektroakustische integrierte Schaltung nach Anspruch 3 oder 4, wobei die piezoelektrische Platte (2') aus Lithiumborat ist.

10. Elektroakustische integrierte Schaltung nach Anspruch 3, wobei die piezoelektrische Platte (2') ein Quarzkristall ist.

11. Elektroakustische integrierte Schaltung nach Anspruch 3 oder 4, wobei das elektroakustische Element ein Oberflächenschallwellen-Bauteil ist.

12. Elektroakustische integrierte Schaltung nach einem der Ansprüche 3 oder 4, wobei das aktive Element einen Transistor (3) einschließt.

13. Elektroakustische integrierte Schaltung nach Anspruch 3 oder 4, wobei die elektroakustische integrierte Schaltung ein Oszillator ist.

14. Elektroakustische integrierte Schaltung nach Anspruch 3 oder 4, wobei die elektroakustische integrierte Schaltung ein Hochfrequenzverstärker ist.

15. Elektroakustische integrierte Schaltung nach Anspruch 3 oder 4, wobei das elektroakustische Element ein Körperschallwellen- Bauteil ist.

16. Herstellungsverfahren einer elektroakustischen integrierten Hybridschaltung, umfassend die Schritte:
Bereitstellen eines Substrats (1') eines Verbindungshalbleiters der III-V-Gruppe, das gegenüberliegende erste und zweite Flächen aufweist;
Bereitstellen einer piezoelektrischen Platte (2), die gegenüberliegende erste und zweite Oberflächen aufweist;
Behandeln der ersten Oberfläche des Substrats (1') eines Verbundhalbleiters der III-V-Gruppe und der zweiten Oberfläche der piezoelektrischen Platte (2), um sie hydrophil zu machen;
Befestigen des Halbleitersubstrats (1') direkt an der piezoelektrischen Platte (2) mit den behandelten Oberflächen, um ein direktes Bonden zu bilden.

17. Herstellungsverfahren einer elektroakustischen integrierten Hybridschaltung, das die Schritte umfaßt:
Bereitstellen eines Siliciumhalbleitersubstrats (1), das gegenüberliegende erste und zweite Oberflächen aufweist;
Bereitstellen einer piezoelektrischen Platte (2'), die gegenüberliegende erste und zweite Oberflächen aufweist, die aus einem Teil, das aus Lithiumniobat, Lithiumtantalat und Lithiumborat ausgewählt ist, besteht;
Behandeln der ersten Oberfläche des Siliciumhalbleitersubstrats (1) und der zweiten Oberfläche der piezoelektrischen Platte (2'), um sie hydrophil zu machen;
Befestigen des Halbleitersubstrats (1) direkt an der piezoelektrischen Platte (2') mit den behandelten Oberflächen, um ein direktes Bonden zu bilden.

18. Herstellungsverfahren einer elektroakustischen integrierten Hybridschaltung nach Anspruch 16 oder 17, wobei als piezoelektrische Platte (2, 2') ein einkristallines piezoelektrisches Substrat bereitgestellt wird.

19. Herstellungsverfahren einer elektroakustischen integrierten Hybridschaltung nach Anspruch 18, das weiterhin den Schritt umfaßt:
Heizen des gebondeten Halbleitersubstrats (1, 1') und der piezoelektrischen Platte (2, 2').

20. Herstellungsverfahren einer elektroakustischen integrierten Hybridschaltung nach einem der Ansprüche 18 oder 19, wobei die hydrophile Behandlung einen Schritt des Verwendens einer Lösung aus Ammoniumhydrogenperoxid umfaßt.

21. Herstellungsverfahren einer elektroakustischen integrierten Hybridschaltung nach Anspruch 19, wobei die Wärmebehandlung bei einer Temperatur von 100 °C bis 500 °C durchgeführt wird.

## Revendications (Revendications pour l'(les) Etat(s) contractant(s) suivant(s): DE, FR, GB)

1. Circuit intégré électroacoustique comprenant :
un substrat de semiconducteur composé du groupe III-V (1),
au moins un élément actif (3, 3') formé à la surface dudit substrat de semiconducteur (1), et
une plaque piézo-électrique (2) qui est liée audit substrat de semiconducteur (1) en joignant directement une surface de ladite plaque piézo-électrique (2) et une surface dudit substrat de semiconducteur (1),
dans lequel au moins un élément électroacoustique comprenant ladite plaque piézo-électrique (2) est relié audit élément actif (3, 3') afin de former un circuit intégré électroacoustique, caractérisé en ce que ladite liaison est une liaison directe.

2. Circuit intégré électroacoustique comprenant :
un substrat de semiconducteur de silicium (1),
au moins un élément actif (3, 3') formé sur la surface dudit substrat de semiconducteur (1), et
une plaque piézo-électrique (2) constituée d'un élément sélectionné entre le niobate de lithium, le tantalate de lithium, et le borate de lithium, qui est liée audit substrat de semiconducteur (1) en joignant directement une surface de ladite plaque piézo-électrique (2) et une surface dudit substrat de semiconducteur (1),
dans lequel au moins un élément électroacoustique comprenant ladite plaque piézo-électrique (2) est relié audit élément actif (3, 3') afin de former un circuit intégré électroacoustique, caractérisé en ce que ladite liaison est une liaison directe.

3. Circuit intégré électroacoustique selon la revendication 1 ou 2, dans lequel la plaque piézo-électrique (2) est un substrat piézo-électrique monocristallin.

4. Amplificateur à haute fréquence comprenant :
un substrat de semiconducteur composé du groupe III-V (1),
au moins un élément actif (3, 3') formé à la surface dudit substrat de semiconducteur (1), et
une plaque piézo-électrique (2) qui est liée audit substrat de semiconducteur (1) en joignant directement une surface de ladite plaque piézo-électrique (2) et une surface dudit substrat de semiconducteur (1),
dans lequel au moins un élément électroacoustique comprenant ladite plaque piézo-électrique (2) est relié audit élément actif (3) afin de former un circuit intégré électroacoustique, caractérisé en ce que ladite liaison est une liaison directe.

5. Amplificateur à haute fréquence comprenant :
un substrat de semiconducteur de silicium (1),
au moins un, élément actif (3, 3') formé sur la surface dudit substrat de semiconducteur (1), et
une plaque piézo-électrique (2) constituée d'un élément sélectionné entre le niobate de lithium, le tantalate de lithium, et le borate de lithium, qui est liée audit substrat de semiconducteur (1) en joignant directement une surface de ladite plaque piézo-électrique (2) et une surface dudit substrat de semiconducteur (1),
dans lequel au moins un élément électroacoustique comprenant ladite plaque piézo-électrique (2') est relié audit élément actif (3, 3') afin de former un circuit intégré électroacoustique, caractérisé en ce que ladite liaison est une liaison directe.

6. Circuit intégré électroacoustique selon la revendication 1 ou 4, dans lequel ledit substrat de semiconducteur composé du groupe III-V (1) est du GaAs.

7. Circuit intégré électroacoustique selon la revendication 1 ou 4, dans lequel ledit substrat de semiconducteur composé du groupe III-V (1) est de l'InP.

8. Amplificateur à haute fréquence selon la revendication 4 ou 5, dans lequel ladite plaque piézo-électrique (2') est du niobate de lithium.

9. Amplificateur à haute fréquence selon la revendication 4 ou 5, dans lequel ladite plaque piézo-électrique (2') est du tantalate de lithium.

10. Amplificateur à haute fréquence selon la revendication 4 ou 5, dans lequel ladite plaque piézo-électrique (2') est du borate de lithium.

11. Amplificateur à haute fréquence selon la revendication 4, dans lequel ladite plaque piézo-électrique (2') est un cristal de quartz.

12. Circuit intégré électroacoustique selon la revendication 1 ou 2, dans lequel ledit élément électroacoustique est un dispositif à onde acoustique de surface.

13. Circuit intégré électroacoustique selon l'une des revendications 1 à 5, dans lequel ledit élément actif comprend un transistor (3).

14. Circuit intégré électroacoustique selon la revendication 1 ou 2, dans lequel ledit circuit intégré électroacoustique est un oscillateur.

15. Circuit intégré électroacoustique selon la revendication 1 ou 2, dans lequel ledit circuit intégré électroacoustique est un amplificateur à haute fréquence.

16. Circuit intégré électroacoustique selon la revendication 1 ou 2, dans lequel ledit élément électroacoustique est un dispositif à ondes acoustiques dans la masse.

17. Procédé de fabrication d'un circuit intégré hybride électroacoustique comprenant les étapes consistant à :
fournir un substrat de semiconducteur composé du groupe III-V (1) présentant des première et seconde surfaces opposées,
fournir une plaque piézo-électrique (2) présentant des première et seconde surfaces opposées, caractérisée par
le traitement de ladite première surface dudit substrat de semiconducteur composé du groupe III-V (1') et de ladite seconde surface de ladite plaque piézo-électrique (2) afin de les rendre hydrophiles,
joindre ledit substrat de semiconducteur (1') directement sur ladite plaque piézo-électrique unique (2) par lesdites surfaces traitées afin de former une liaison directe.

18. Procédé de fabrication d'un circuit intégré hybride électroacoustique comprenant les étapes consistant à :
fournir un substrat de semiconducteur de silicium (1) comportant des première et seconde surfaces opposées,
fournir une plaque piézo-électrique (2), comportant des première et seconde surfaces opposées, caractérisée par
le traitement de ladite première surface dudit substrat de semiconducteur de silicium (1) et de ladite seconde surface de ladite plaque piézo-électrique (2) afin de les rendre hydrophiles,
la jonction dudit substrat de semiconducteur (1) directement sur ladite plaque piézo-électrique (2) par lesdites surfaces traitées afin de former une liaison directe.

19. Procédé de fabrication d'un amplificateur à haute fréquence comprenant les étapes consistant à :
fournir un substrat de semiconducteur composé du groupe III-V (1') comportant des première et seconde surfaces opposées,
fournir une plaque piézo-électrique (2) présentant des première et seconde surfaces opposées, caractérisée par
le traitement de ladite première surface dudit substrat de semiconducteur composé du groupe III-V (1') et de ladite seconde surface de ladite plaque piézo-électrique (2) afin de les rendre hydrophiles,
la jonction dudit substrat de semiconducteur (1') directement sur ladite plaque piézo-électrique (2) par les surfaces traitées afin de former une liaison directe.

20. Procédé de fabrication d'un amplificateur à haute fréquence comprenant les étapes consistant à :
fournir un substrat de semiconducteur de silicium (1) comportant des première et seconde surfaces opposées,
fournir une plaque piézo-électrique (2'), comportant des première et seconde surfaces opposées, constituée d'un élément sélectionné entre le niobate de lithium, le tantalate de lithium, et le borate de lithium, caractérisée par
le traitement de ladite première surface dudit substrat de semiconducteur de silicium (1) et de ladite seconde surface de ladite plaque piézo-électrique (2') afin de les rendre hydrophiles,
la jonction dudit substrat de semiconducteur (1) directement sur ladite plaque piézo-électrique (2') par lesdites surfaces traitées afin de former une liaison directe.

21. Procédé de fabrication d'un amplificateur à haute fréquence selon la revendication 19 ou 20, dans lequel un substrat piézo-électrique monocristallin est prévu en tant que plaque piézo-électrique (2, 2').

22. Procédé de fabrication selon la revendication 21, comprenant en outre l'étape consistant à :
chauffer ledit substrat de semiconducteur lié (1, 1') et ladite plaque piézo-électrique (2, 2').

23. Procédé de fabrication selon l'une des revendications 21 ou 22, dans lequel ledit traitement hydrophile comprenant une étape utilisant une solution d'ammoniaque-peroxyde d'hydrogène.

24. Procédé de fabrication selon la revendication 22, dans lequel ledit traitement thermique est exécuté à une température entre 100° C et 500° C.

## Revendications (Revendications pour l'(les) Etat(s) contractant(s) suivant(s): NL, SE)

1. Circuit intégré électro-acoustique comprenant :
un substrat semi-conducteur d'un composé du groupe III-V (1') ;
au moins un élément actif (3,3') formé sur la surface dudit substrat semi-conducteur (1') ; et
une plaque piézoélectrique (2) étant soudée audit substrat semi-conducteur (1) ;
dans lequel au moins un élément électro-acoustique comprenant ladite plaque piézoélectrique (2) est connecté audit élément actif (3) pour former un circuit intégré électro-acoustique ;
caractérisé en ce que :
la plaque piézoélectrique (2) est soudée par l'intermédiaire d'un soudage direct au substrat semi-conducteur (1').

2. Circuit intégré électro-acoustique comprenant :
un substrat semi-conducteur au silicium (1) ;
au moins un élément actif (3,3') formé sur la surface dudit substrat semi-conducteur (1) ; et
une plaque piézoélectrique (2'), qui est constituée d'un élément choisi parmi le niobate de lithium, le tantalate de lithium et le borate de lithium, étant soudée audit substrat semi-conducteur ;
dans lequel au moins un élément électro-acoustique comprenant ladite plaque piézoélectrique (2') est connecté audit élément actif (3,3') pour former un circuit intégré électro-acoustique ;
caractérisé en ce que /
la plaque piézoélectrique (2') est soudée par l'intermédiaire d'un soudage direct au substrat semi-conducteur (1).

3. Circuit intégré électro-acoustique selon la revendication 1, dans lequel ladite plaque piézoélectrique (2') est un substrat piézoélectrique monocristallin.

4. Circuit intégré électro-acoustique selon la revendication 2, dans lequel ladite plaque piézoélectrique (2) est un substrat piézoélectrique monocristallin.

5. Circuit intégré électro-acoustique selon la revendication 3, dans lequel ledit substrat semi-conducteur d'un composé du groupe III-V (1') est GaAs.

6. Circuit intégré électro-acoustique selon la revendication 3, dans lequel ledit substrat semi-conducteur d'un composé du groupe III-V (1') est InP.

7. Circuit intégré électro-acoustique selon la revendication 3 ou 4, dans lequel ladite plaque piézoélectrique (2') est constituée de niobate de lithium.

8. Circuit intégré électro-acoustique selon la revendication 3 ou 4, dans lequel ladite plaque piézoélectrique (2') est constituée de tantalate de lithium.

9. Circuit intégré électro-acoustique selon la revendication 3 ou 4, dans lequel ladite plaque piézoélectrique (2') est constituée de borate de lithium.

10. Circuit intégré électro-acoustique selon la revendication 3, dans lequel ladite plaque piézoélectrique (2') est constituée de quartz.

11. Circuit intégré électro-acoustique selon la revendication 3 ou 4, dans lequel ledit élément électro-acoustique est un dispositif à onde acoustique en surface.

12. Circuit intégré électro-acoustique selon la revendication 3 ou 4, dans lequel ledit élément actif inclut un transitor (3).

13. Circuit intégré électro-acoustique selon la revendication 3 ou 4, dans lequel ledit circuit intégré électro-acoustique est un oscillateur.

14. Circuit intégré électro-acoustique selon la revendication 3 ou 4, dans lequel ledit circuit intégré électro-acoustique est un amplificateur haute fréquence.

15. Circuit intégré électro-acoustique selon la revendication 3 ou 4, dans lequel ledit élément électro-acoustique est un dispositif à onde acoustique en profondeur.

16. Procédé de fabrication d'un circuit intégré hybride électro-acoustique comprenant les étapes consistant à :
fournir un substrat semi-conducteur d'un composé du groupe III-V (1') comportant des première et seconde surfaces opposées ;
fournir une plaque piézoélectrique (2) comportant des première et seconde surfaces opposées ;
traiter ladite première surface dudit substrat semi-conducteur du composé du groupe III-V (1') et ladite seconde surface de ladite plaque piézoélectrique (2) pour les rendre hydrophiles ;
attacher ledit substrat semi-conducteur (1') directement à ladite plaque piézoélectrique (2) avec lesdites surfaces traitées pour former une connexion directe.

17. Procédé de fabrication d'un circuit intégré hybride électro-acoustique comprenant les étapes consistant à :
fournir un substrat semi-conducteur au silicium (1) comportant des première et seconde surfaces opposées ;
fournir une plaque piézoélectrique (2'), comportant des première et seconde surfaces opposées, constituées d'un élément choisi parmi le niobate de lithium, le tantalate de lithium et le borate de lithium ;
traiter ladite première surface dudit substrat semi-conducteur au silicium (1) et ladite seconde surface de ladite plaque piézoélectrique (2') pour les rendre hydrophiles ;
attacher ledit substrat semi-conducteur (1) directement à ladite plaque piézoélectrique (2') avec lesdites surfaces traitées pour former une connexion directe.

18. Procédé de fabrication d'un circuit intégré hybride électro-acoustique selon la revendication 16 ou 17, dans lequel, en tant que plaque piézoélectrique (2, 2'), il est prévu un substrat piézoélectrique monocristallin.

19. Procédé de fabrication d'un circuit intégré hybride électro-acoustique selon la revendication 18, comprenant de plus l'étape consistant à : chauffer ledit substrat semi-conducteur (1, 1') et ladite plaque piézoélectrique (2, 2') soudés.

20. Procédé de fabrication d'un circuit intégré hybride électro-acoustique selon la revendication 18 ou 19, dans lequel ledit traitement hydrophile comprend une étape consistant à utiliser une solution d'ammoniaque-peroxyde d'hydrogène.

21. Procédé de fabrication d'un circuit intégré hybride électro-acoustique selon la revendication 19, dans lequel ledit traitement thermique est effectué à une température située entre 100°C et 500°C.
